# EUROPEAN PATENT APPLICATION

(11) **EP 4 640 691 A1**
(43) Date of publication of application: **29.10.2025**
(21) Application number: 25152469.0
(22) Date of filing: 17.01.2025
(51) Int. Cl.: C07F 15/00, C09K 11/06

(54) **[2,2]PARACYCLOPHANE-BASED METAL (II) COMPLEXES, ELECTRONIC DEVICES, APPARATUS, AND USE THEREOF**

(30) Priority: 28.04.2024 CN 202410518631
(71) Applicant: Zhejiang Huaxian Photoelectricity Technology Co., Ltd, Jiaxing, Zhejiang 314107 (CN); Zhejiang University of Technology, Hangzhou, Zhejiang 310014 (CN)
(72) Inventor: LI, Guijie, Hangzhou, 310014 (CN); LIN, Jiaoying, Hangzhou, 310014 (CN); SHE, Yuanbin, Hangzhou, 310014 (CN); HUANG, Disheng, Hangzhou, 310014 (CN); ZHAO, Xiaoyu, Jiaxing, 314107 (CN)
(74) Representative: Chung, Hoi Kan

(57) **Abstract**

The disclosure is in the field of organic electroluminescence and particularly relates to [2,2]paracyclophane-based metal (II) complexes, electronic devices, apparatus, and use thereof. The disclosure provides a metal platinum (II) complexes introducing a planar-chiral [2,2]paracyclophane on an azacyclic carbene, which enhances the photochemical stability of the tetradentate platinum (II) complex and prevents undesirable host and guest interactions, helping to extend device lifetime and achieve higher color purity. The materials according to the disclosure all have good chemical stability and thermal stability, and are easy to prepare an evaporation-type OLED device. The organic electroluminescent device fabricated using the compound of the disclosure as a light-emitting layer shows a significant improvement in current efficiency and lifetime and a significant reduction in light-emitting voltage. In particular, the combination with the fluorescent doping material balances hole and electron transport, allowing for more efficient energy transfer between host and guest.

## Description

### TECHNICAL FIELD

The disclosure is in the field of organic electroluminescence and particularly relates to [2,2]paracyclophane-based metal (II) complexes, electronic devices, apparatus, and use thereof.

### BACKGROUND

Organic light-emitting diodes (OLED) are a new generation of full-color display and lighting technology. Compared with the shortcomings of liquid crystal display, such as slow response speed, small viewing angle, need for a backlight, and high energy consumption, OLED, as an autonomous light-emitting device, does not require backlight and is energy-saving; it also has low driving voltage, fast response speed, high resolution and contrast, wide viewing angle, and outstanding low-temperature performance; OLED devices can be made thinner and can be made into flexible structures. In addition, it has the advantages of low production cost, simple production process, and large-area production. Therefore, OLED has a wide and huge application prospect in high-end electronics and aerospace; with the gradual increase in investment, further in-depth research and development, and the upgrading of production equipment, OLEDs will have very broad application scenarios and development prospects in the future.

The core of OLED development is the design and development of light-emitting materials. In the currently used OLED devices, almost all the light-emitting layers use the host-guest light-emitting system mechanism, namely, the host material is doped with a guest light-emitting material, the energy system of the host material is generally greater than that of the guest light-emitting material, and energy is transferred from the host material to the guest material so that the guest material is excited to emit light. Commonly used organic phosphorescent guest materials are generally heavy metal atoms such as iridium (III), platinum (II), palladium (II), etc. The low cost of platinum (II) complex phosphorescent materials has great application prospects. However, there are still some technical difficulties in the development of platinum complex materials and devices, how to reduce the height of the shoulder peak in the emission spectrum to improve the color purity of the luminescence of material molecules? This problem is particularly important for blue and deep blue light-emitting materials, which have a large impact on the efficiency and energy utilization of commercially available top-emitting devices. Therefore, there is a need to develop novel phosphorescent metal platinum (II) complexes.

### SUMMARY

It is an object of the disclosure to provide one or more guest phosphorescent materials for use in organic electroluminescent devices. Specifically providing platinum (II) complexes introducing [2,2]paracyclophane on an azacyclic carbene, the [2,2]paracyclophane enhances the photochemical stability of the tetradentate platinum (II) complexes; effectively preventing undesirable host and guest interactions helps to extend device lifetime and achieve higher color purity.

An exemplary embodiment of the disclosure provides a metal platinum (II) complex having the structure shown in Formula (I): 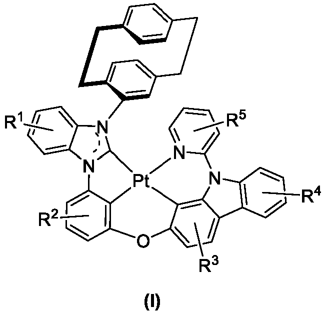 wherein, in Formula (I), R¹ is hydrogen, deuterium; R², R³, R⁴ and R⁵ are each independently represented by mono-, di-, tri-, tetra- or unsubstituted; R², R³, R⁴ and R⁵, equal to or different from each other, are each independently selected from any one or more of the following groups: hydrogen, deuterium, halogen, cyano, substituted or unsubstituted C1-C30 linear or branched alkyl, substituted or unsubstituted C1-C30 linear or branched alkenyl, substituted or unsubstituted C1-C30 linear or branched alkynyl, substituted or unsubstituted C6-C60 monocyclic or polycyclic aryl.

Preferably, when containing substituents, the substituents are selected from one or more of deuterium, F, methyl, ethyl, n-propyl, isopropyl, tert-butyl, phenyl.

All hydrogen atoms in Formula (I) may be substituted by deuterium atoms.

Further, the disclosure also provides the use of the metal platinum (II) complex having the structure shown in Formula (I) above in an electronic device.

Further, the electronic device is selected from the group consisting of an organic light-emitting diode, a light-emitting electrochemical cell, an OLED sensor, an organic diode, an organic solar cell, an organic transistor, an organic field effect transistor, an organic laser, and a down-conversion element.

Another exemplary embodiment of the disclosure provides an electronic device comprising: a substrate, an anode, and a cathode, wherein the anode or cathode is provided on the substrate; and a light-emitting material layer disposed between the anode and the cathode, the light-emitting material layer including the metal platinum (II) complex having the structure shown by the above Formula (I).

Another exemplary embodiment of the disclosure provides an organic electroluminescent device comprising: A first electrode; a second electrode facing the first electrode; and an organic functional layer sandwiched between the first electrode and the second electrode; wherein the organic functional layer comprises a light-emitting layer comprising a metal platinum (II) complex having a structure shown in the above Formula (I).

Further, the organic electroluminescent device is a full-color display, a light-emitting display device, or an organic light-emitting diode. The mass percentage of the metal platinum (II) complex in the organic electroluminescent device is 0.01% to 50%.

The disclosure also provides a composition comprising a metal platinum (II) complex having a structure shown in the above Formula (I).

The disclosure also provides a formulation comprising a metal platinum (II) complex having the structure shown in Formula (I) above and at least one solvent.

The disclosure also provides a display or lighting apparatus comprising an organic electroluminescent device comprising a metal platinum (II) complex having a structure shown in Formula (I).

Compared to the prior art, the advantageous effects of the disclosure are:

the disclosure provides metal platinum (II) complexes introducing planar-chiral [2,2]paracyclophane on an azacyclic carbene, which enhances the photochemical stability of the tetradentate platinum (II) complexes and prevents undesirable host and guest interactions, helping to extend the device lifetime and achieve higher color purity. The materials according to the disclosure all have good chemical stability and thermal stability, and are easy to prepare an evaporation-type OLED device. The organic electroluminescent device fabricated using the compound of the disclosure as a light-emitting layer shows a significant improvement in current efficiency and lifetime and a significant reduction in light-emitting voltage. In particular, the combination with the fluorescent doping material balances hole and electron transport, allowing for more efficient energy transfer between host and guest.

### BRIEF DESCRIPTION OF DRAWINGS

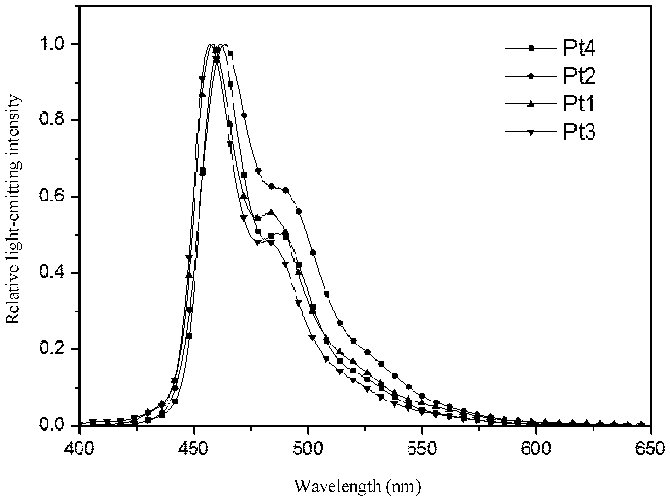

The figure is a room temperature emission spectrogram of platinum complexes Pt1, Pt2, Pt3, and Pt4 in a dichloromethane solution.

### DETAILED DESCRIPTION OF THE EMBODIMENTS

Hereinafter, the disclosure will be described in detail. The following description of the constituent elements is sometimes based on a representative embodiment or embodiment of the disclosure, but the disclosure is not limited to this embodiment or embodiment.

As used herein, the term "substituted" is intended to comprise all permissible substituents of organic compounds. In a broad aspect, the permissible substituents include acyclic and cyclic, branched and unbranched, carbocyclic and heterocyclic, and aromatic and nonaromatic substituents of organic compounds. Illustrative substituents include, for example, those described below. The permissible substituents can be one or more and the same or different for appropriate organic compounds. For purposes of this invention, a heteroatom (e.g. nitrogen) can have hydrogen substituents and/or any permissible substituents of organic compounds described herein which satisfy the valences of the heteroatom. This invention is not intended to be limited in any manner by the permissible substituents of organic compounds. Likewise, the term "substituted" or "substituted with" includes the implicit proviso that such substitution is in accordance with the permitted valence of the substituted atom and the substituent and that the substitution results in a stable compound (e.g. a compound that does not spontaneously undergo transformation such as by rearrangement, cyclization, elimination, etc.). It is also contemplated that, in certain aspects, unless expressly stated to the contrary, individual substituents can be further optionally substituted (i.e. further substituted or unsubstituted).

In defining various terms, "R₁"-"R₁₂" are used herein as general symbols to represent various specific substituents. These symbols can be any substituents, not limited to those disclosed herein, and when they are limited in one instance to certain substituents, they can be limited in other instances to some other substituents.

As used herein, "R₁", "R₂", "R₃"..."Rₙ" (where n is an integer) can independently have one or more of the groups listed above. For example, if R¹ is a straight chain alkyl, one hydrogen atom of the alkyl may be optionally substituted with hydroxyl, alkoxy, alkyl, halogen, and the like. Depending on the group selected, the first group may be incorporated within the second group, or alternatively, the first group may be pendant, i.e. attached, to the second group. The nature of the selected group will determine whether the first group is embedded in or attached to the second group.

The term "alkyl" as used herein is a branched or unbranched saturated hydrocarbon group of 1 to 30 carbon atoms, preferred alkyls are alkyls containing 1 to 20 carbon atoms, more preferably 1 to 9 carbon atoms. Examples are methyl, ethyl, n-propyl, isopropyl, n-butyl, isobutyl, sec-butyl, tert-butyl, n-pentyl, isopentyl, sec-pentyl, neopentyl, hexyl, heptyl, hemi-, nonyl, decyl, dodecyl, tetradecyl, hexadecyl, eicosyl, tetracosyl and the like. The alkyl may be cyclic or acyclic. The alkyl may be branched or unbranched. The alkyl may also be substituted or unsubstituted. For example, the alkyl may be substituted with one or more groups including, but not limited to, an optionally substituted alkyl, cycloalkyl, alkoxy, amino, halogen, hydroxy, nitro, silyl, sulfo-oxo, or mercapto as described herein.

As used herein, the term "aryl" is a radical of any carbon-based aromatic group containing from 6 to 60 carbon atoms, with preferred aryl groups being aromatic groups containing from 6 to 30 carbon atoms, more preferably from 6 to 18 carbon atoms. Such carbon-based aromatic groups include, but are not limited to, phenyl, naphthyl, phenyl, biphenyl, phenoxyphenyl, anthracenyl, phenanthrenyl, and the like. The term "aryl" also includes "heteroaryl", which is defined as a group containing an aromatic group having at least one heteroatom introduced within the ring of the aromatic group. Examples of heteroatoms include but are not limited to, nitrogen, oxygen, sulfur, and phosphorus. An aryl group can be substituted or unsubstituted. Aryl groups can be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxyl, ester, halogen, hydroxyl, carbonyl, azido, nitro, silyl, sulfo-oxo, or mercapto as described herein.

According to an exemplary embodiment of the disclosure, there is provided a metal platinum (II) complex having a structure shown in Formula (I): 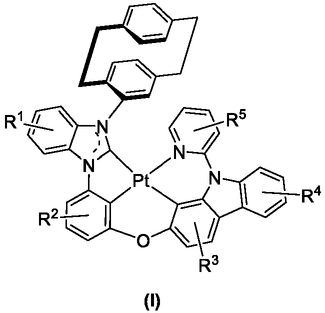 wherein, in Formula (I), R¹ is hydrogen, deuterium; R², R³, R⁴ and R⁵ are each independently represented by mono-, di-, tri-, tetra- or unsubstituted; R², R³, R⁴ and R⁵, equal to or different from each other, are each independently selected from any one or more of the following groups: hydrogen, deuterium, halogen, cyano, substituted or unsubstituted C1-C30 linear or branched alkyl, substituted or unsubstituted C1-C30 linear or branched alkenyl, substituted or unsubstituted C1-C30 linear or branched alkynyl, substituted or unsubstituted C6-C60 monocyclic or polycyclic aryl.

Preferably, R², R³, R⁴ and R⁵, equal to or different from each other, are each independently selected from any one or more of the following groups: hydrogen, deuterium, F, cyano, substituted or unsubstituted C1-C10 linear or branched alkyl, substituted or unsubstituted C6-C30 monocyclic aryl; when containing substituents, the substituents are selected from one or more of deuterium, F, methyl, ethyl, n-propyl, isopropyl, tert-butyl, phenyl.

All hydrogen atoms in Formula (I) may be substituted by deuterium atoms.

According to an exemplary embodiment of the disclosure, it is provided that Formula (I) may be selected from the following structures:

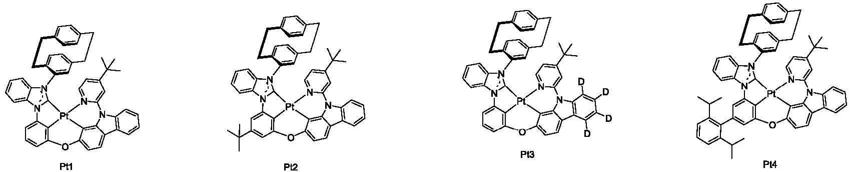

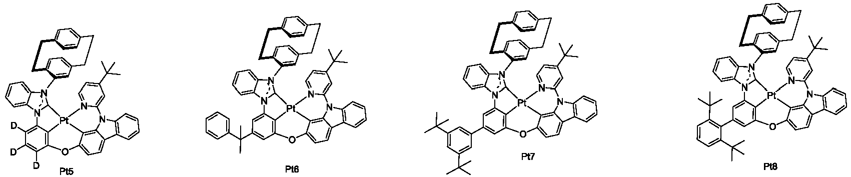

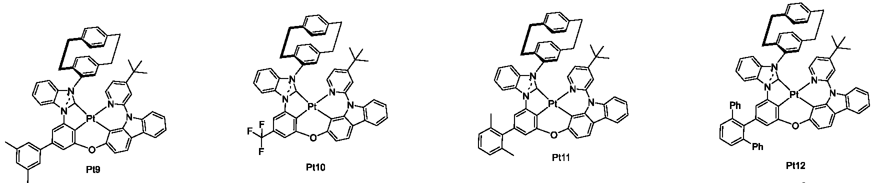

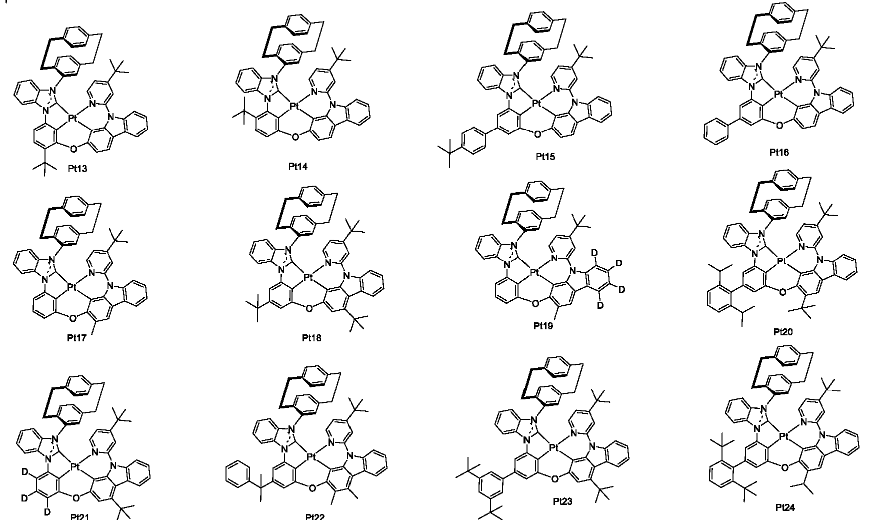

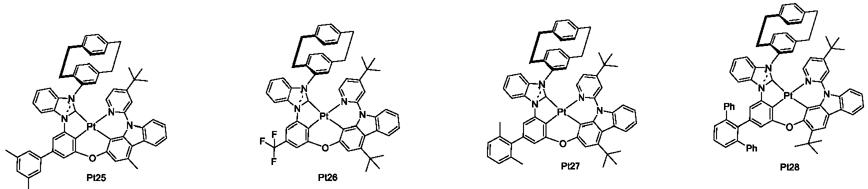

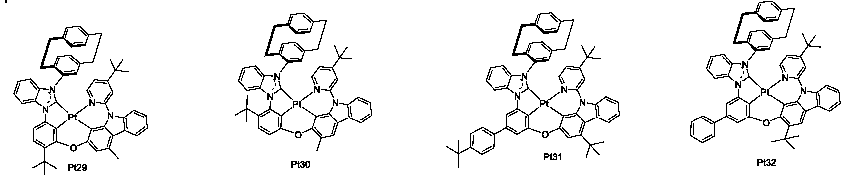

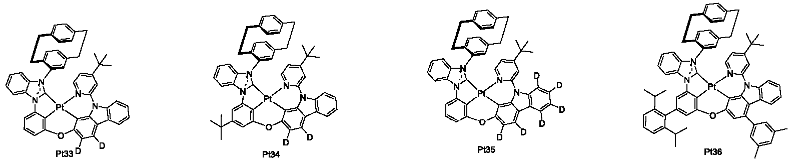

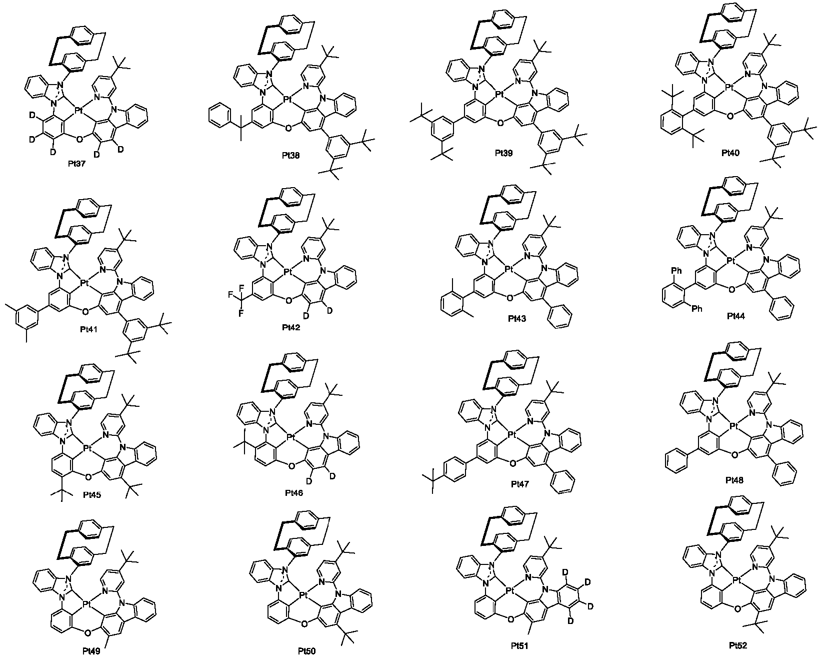

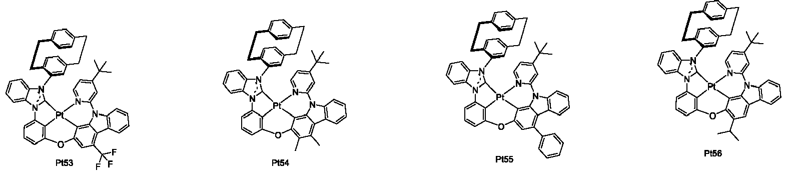

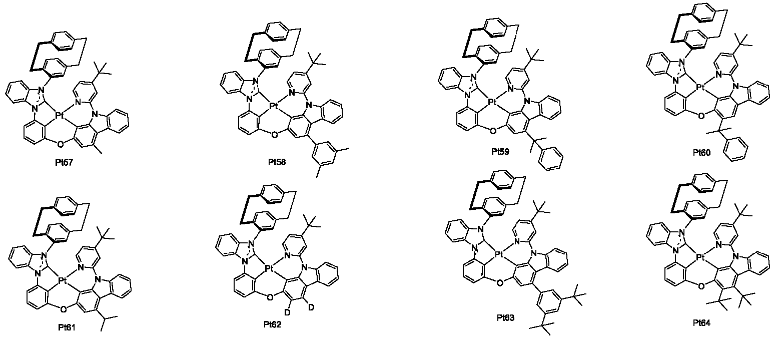

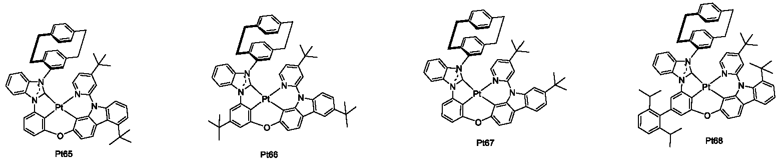

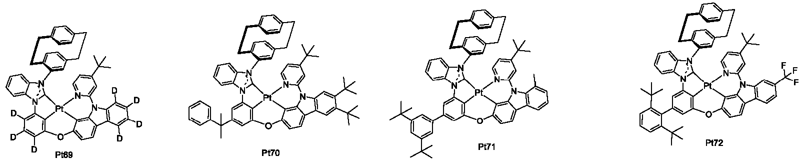

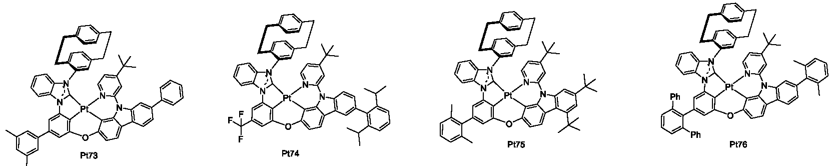

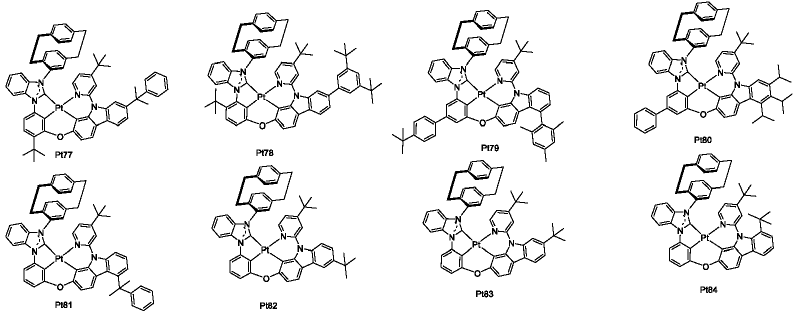

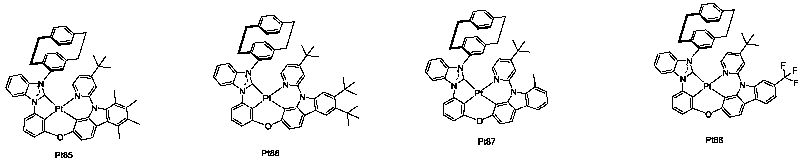

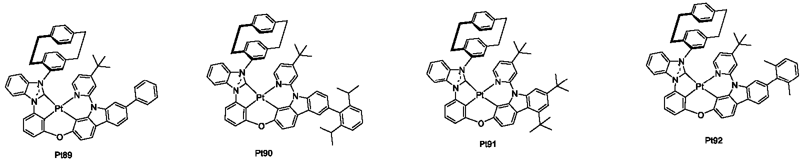

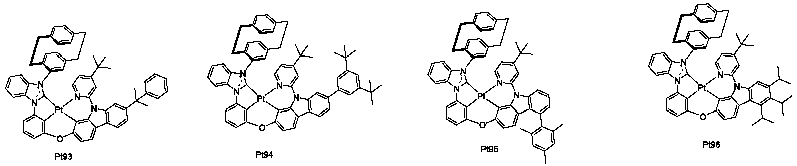

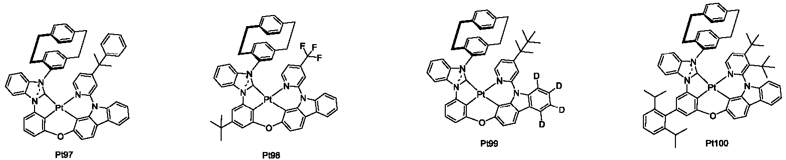

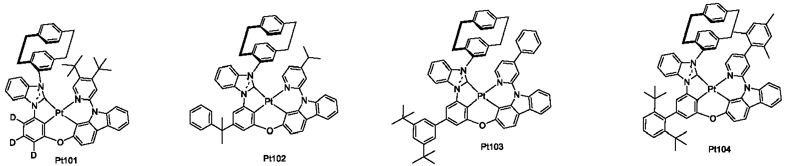

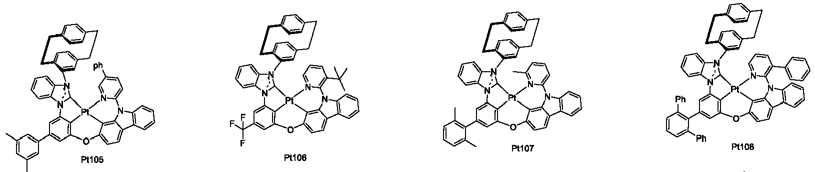

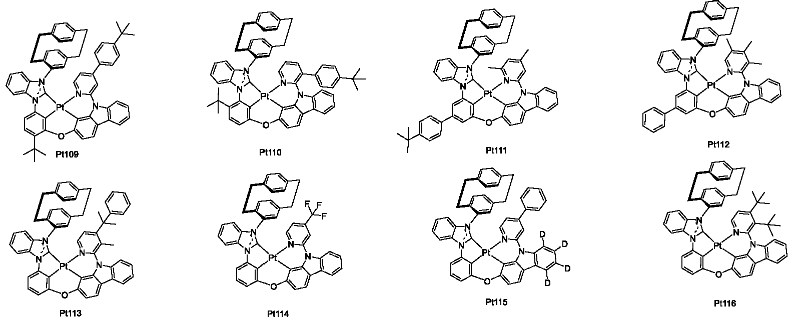

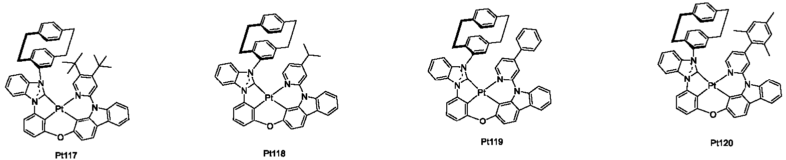

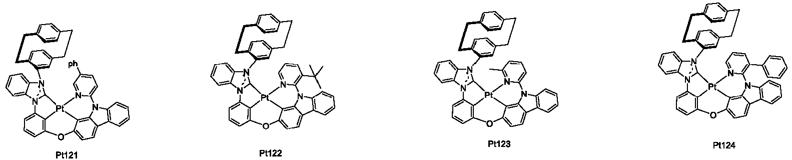

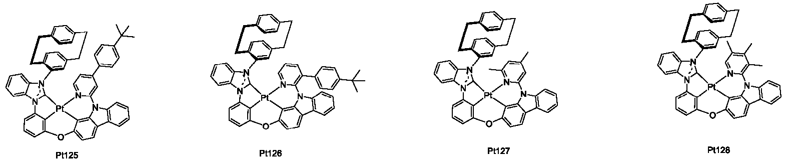

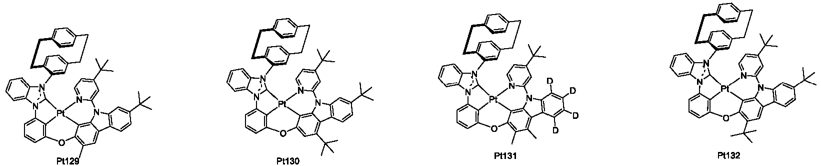

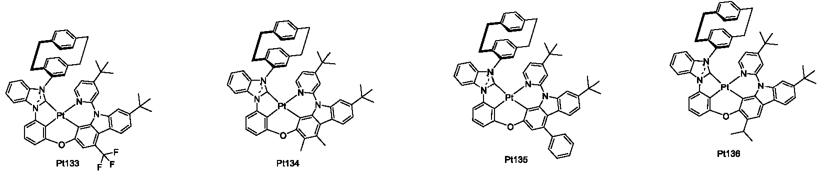

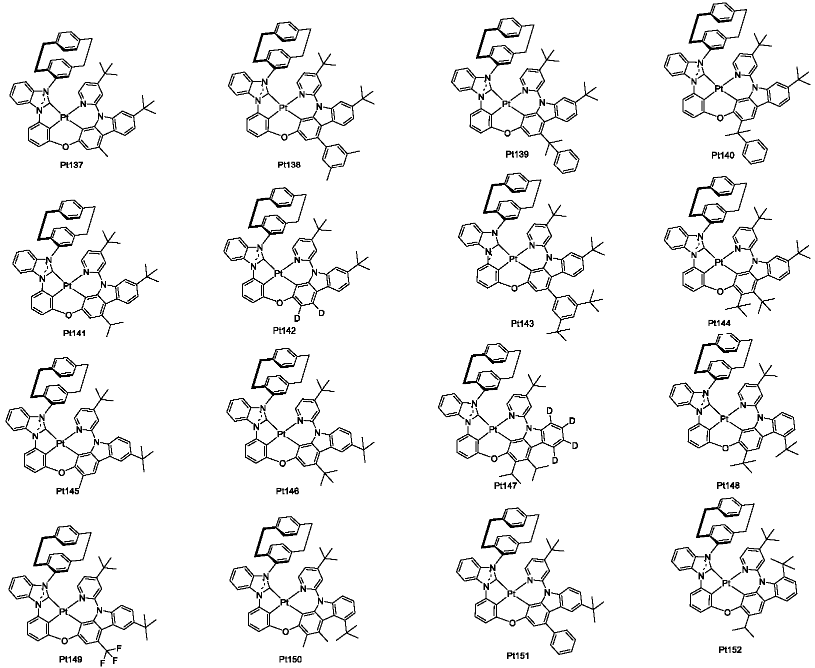

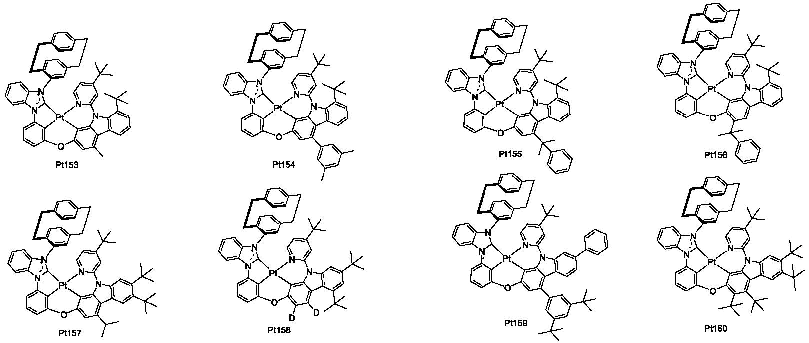

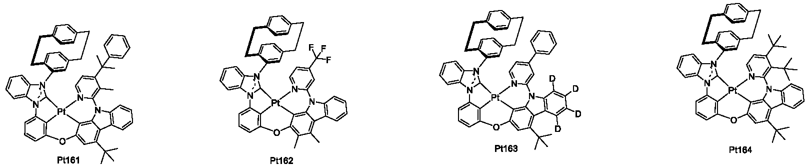

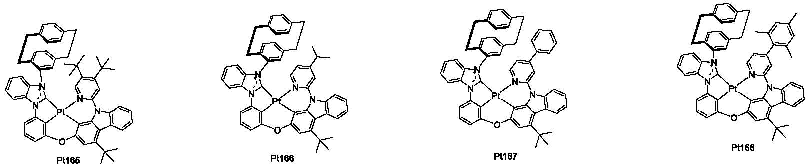

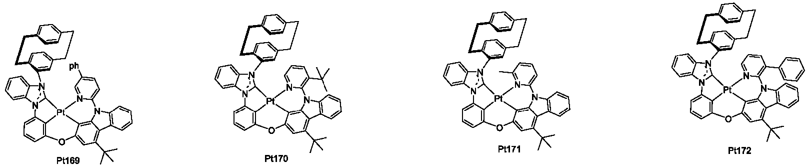

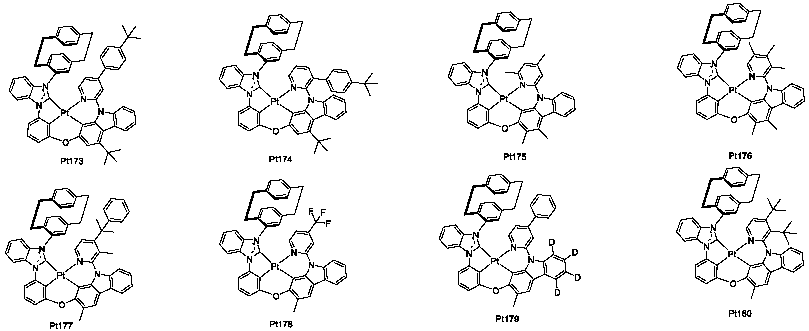

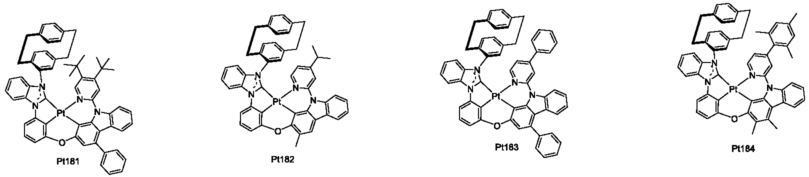

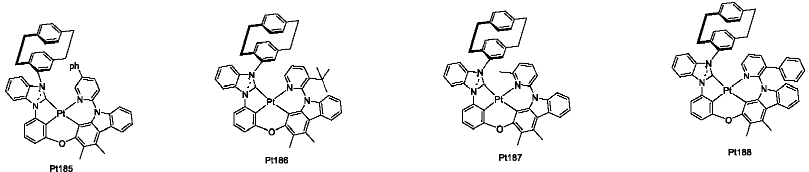

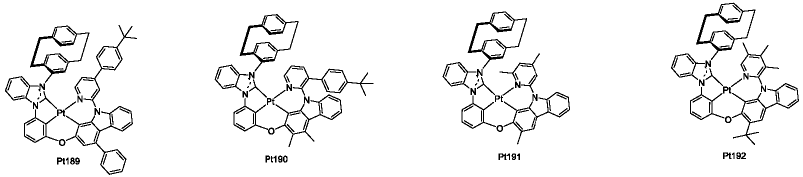

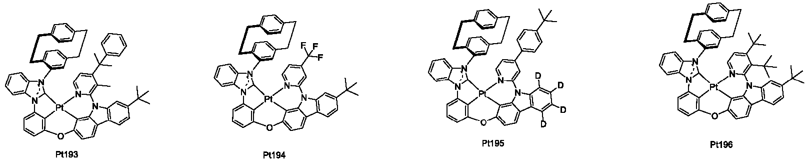

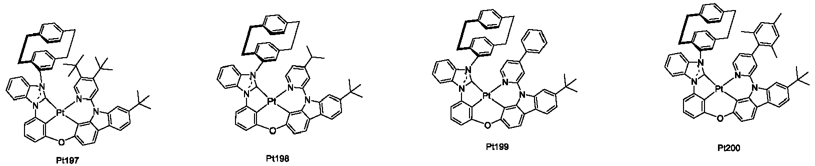

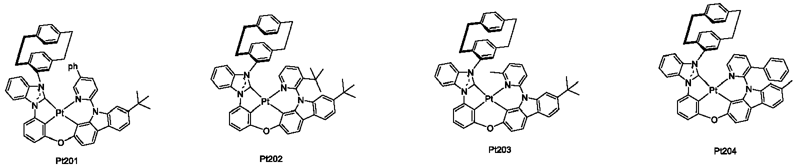

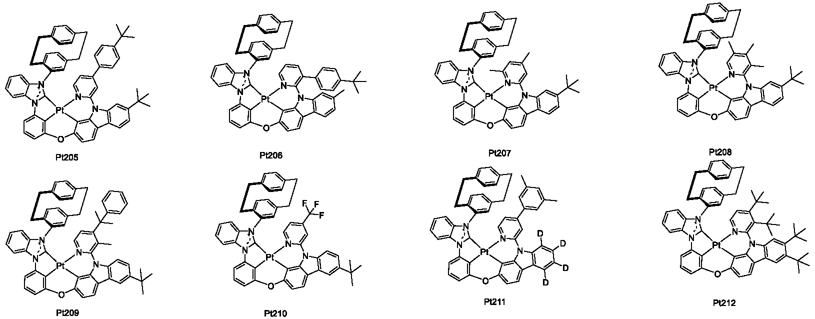

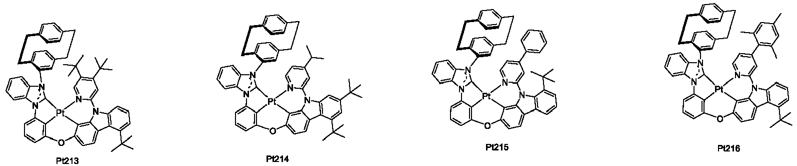

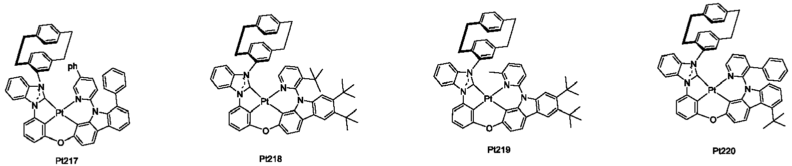

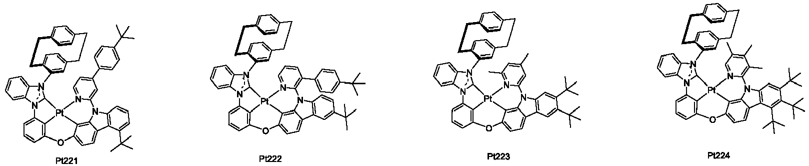

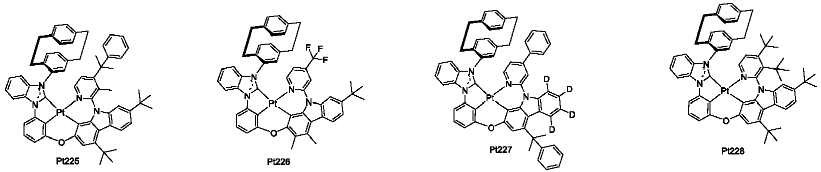

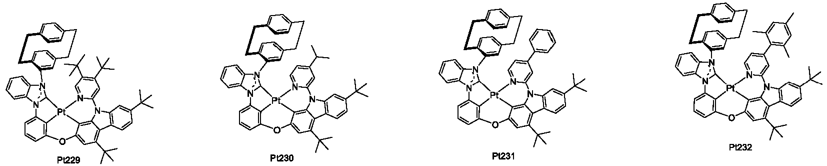

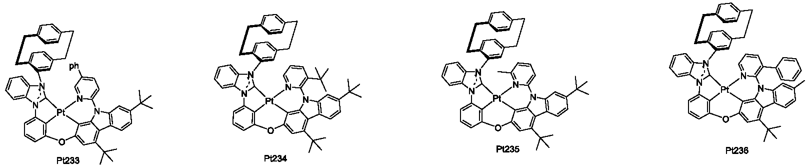

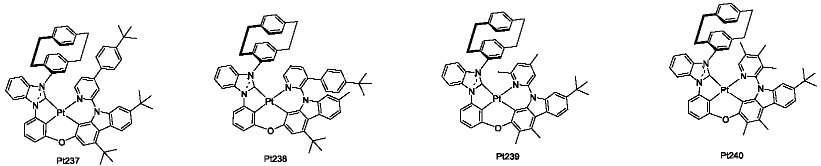

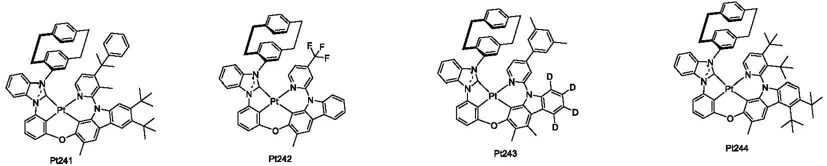

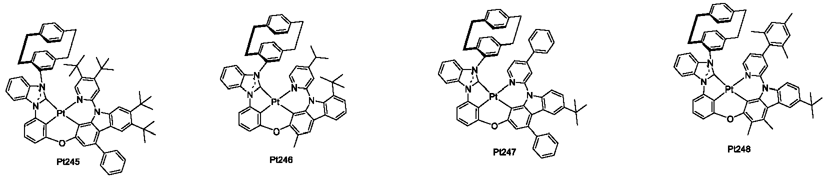

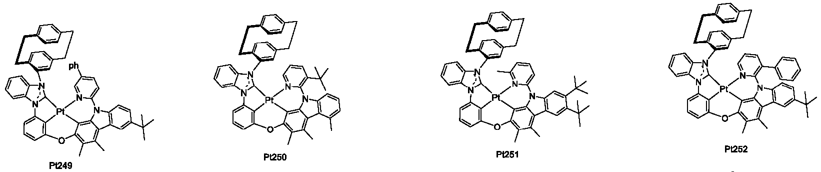

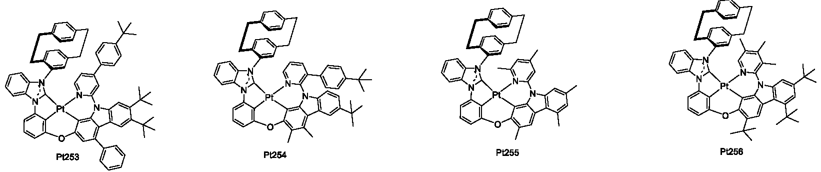

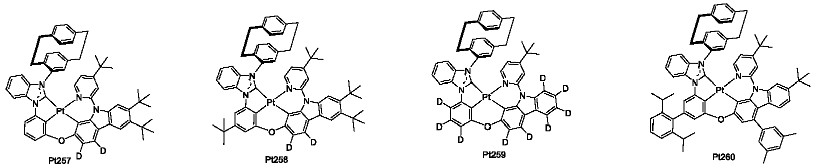

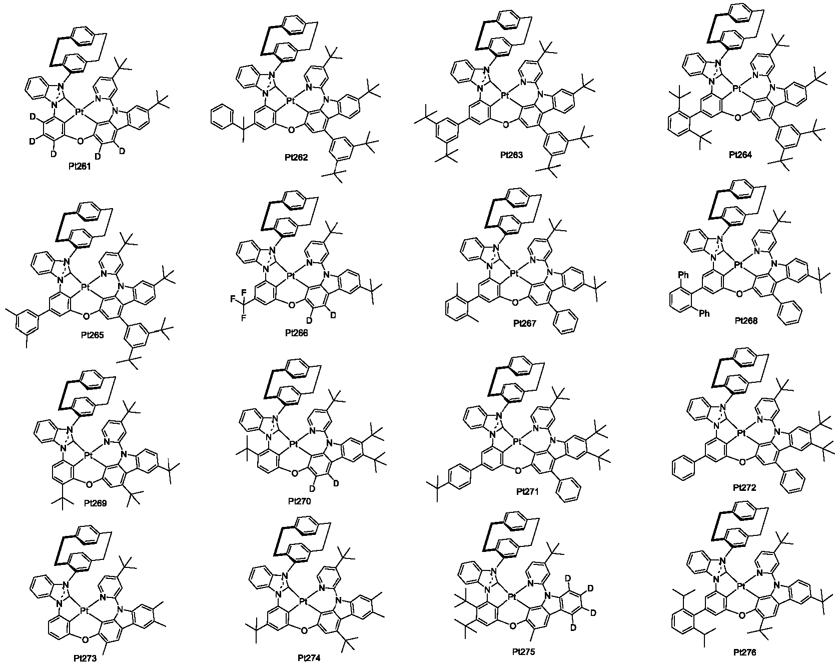

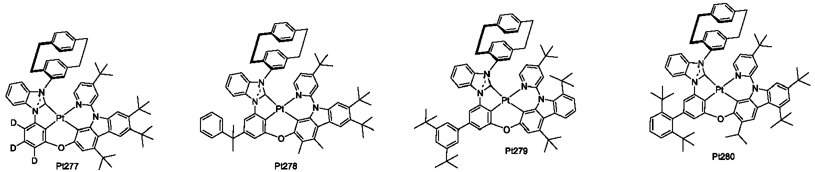

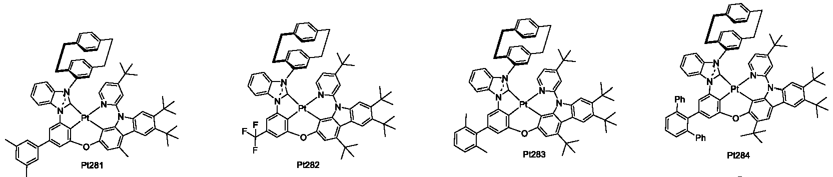

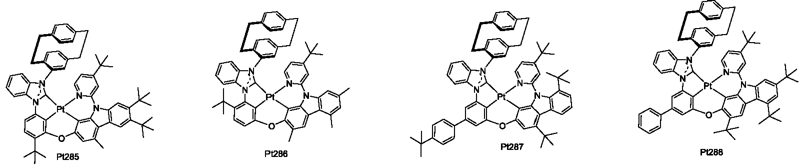

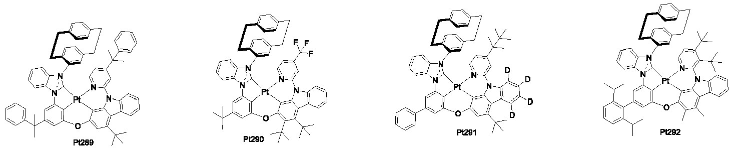

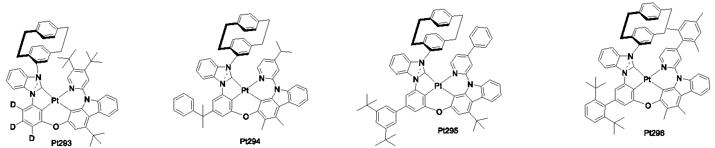

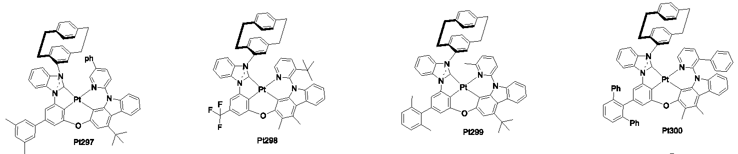

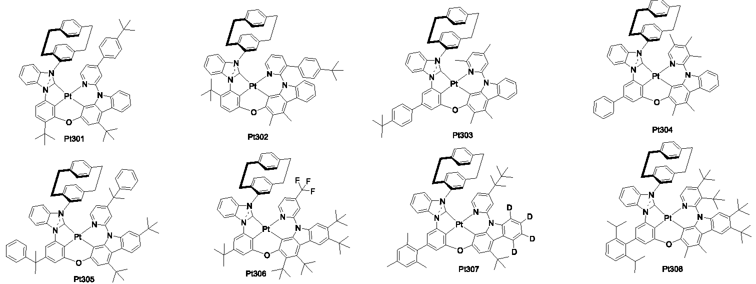

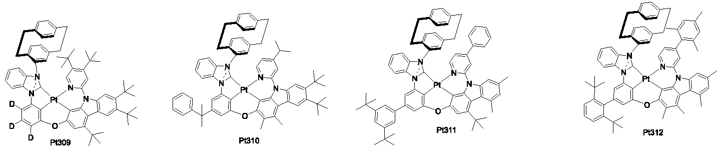

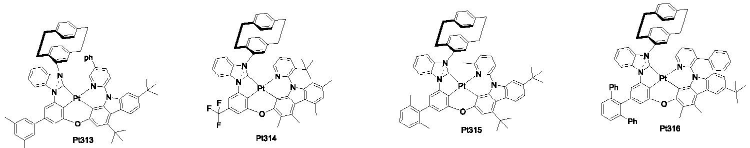

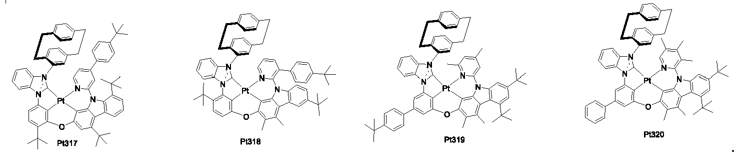

Another exemplary embodiment of the disclosure provides a composition comprising a guest material and a host material; the guest material is selected from a metal platinum (II) complex having the structure shown in the above Formula (I).

Preferably, the composition further comprises a fluorescent doping material; the fluorescent doping material is selected from any one or more of the compounds of Formula (BN1) - Formula (BN5): 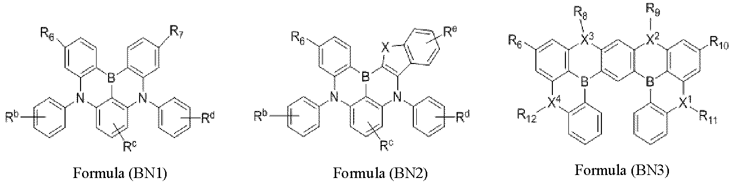 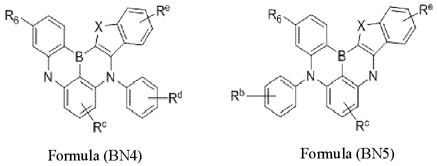
wherein X is O, S, Se, or NR³⁰⁰;
X¹, X², X³, and X⁴ are each independently represented by O, S, Se, or N;
R^{b}-R^{e} are each independently represented by mono-, di-, tri-, tetra-, or unsubstituted; R^{b}-R^{e} are each independently selected from the group consisting of hydrogen, deuterium, N, C1-C30 alkyl, C6-C60 aryl; the R₆-R₁₂ are each independently represented by the group consisting of hydrogen, deuterium, N, C1-C30 alkyl, C6-C60 aryl, and C6-C60 heteroaryl.

Preferably, R₆, R₇, and R₁₀ are each independently selected from a substituted or unsubstituted diphenylamino group and a substituted or unsubstituted carbazolyl group; the substitution may be multiple when containing substituents, the substituents are selected from deuterium, C1-C30 alkyl, and C6-C30 aryl.

Preferably, the R³⁰⁰, R₈, R₉, R₁₁, and R₁₂ are each independently selected from the group consisting of hydrogen, C1-C30 alkyl, and C6-C60 aryl.

Further, the fluorescent doping material is selected from any one of the chemical structures shown below, wherein Ph represents a phenyl group and D4 and D5 mean substitution with 4 and 5 deuterium atoms, respectively:

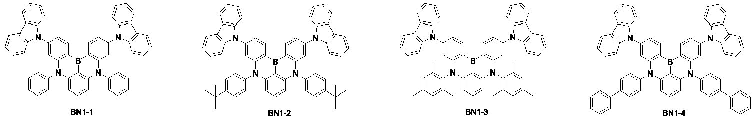

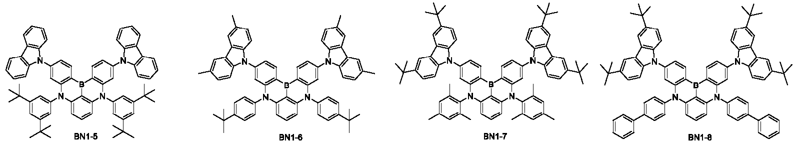

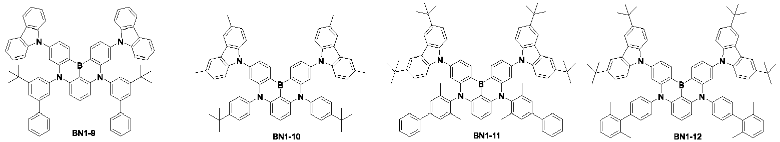

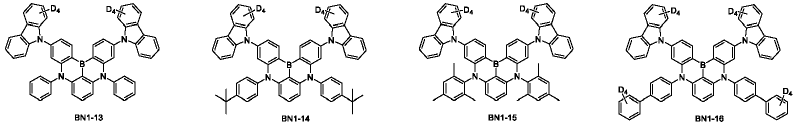

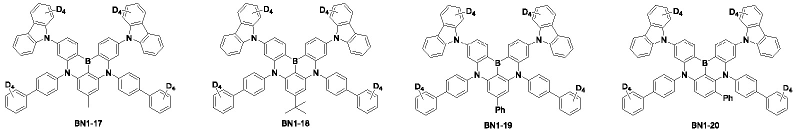

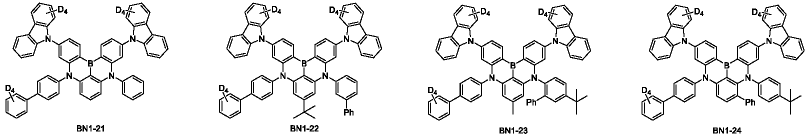

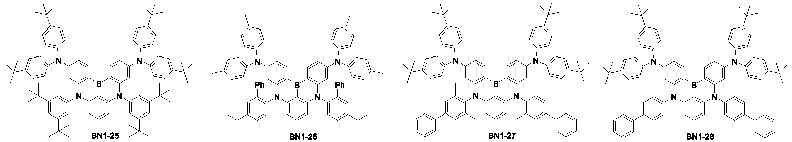

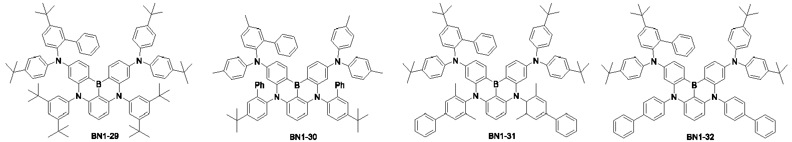

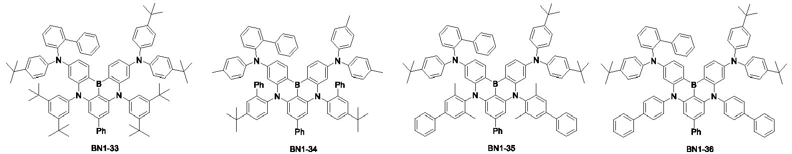

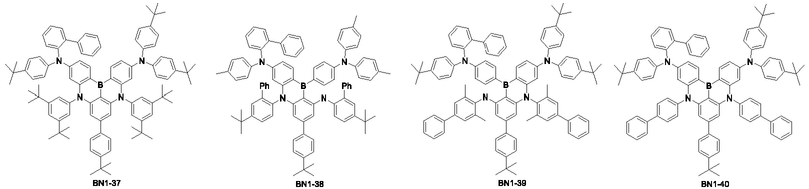

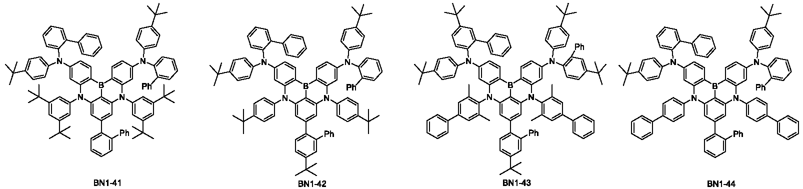

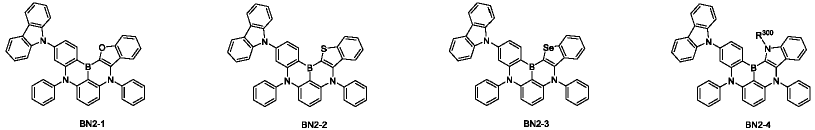

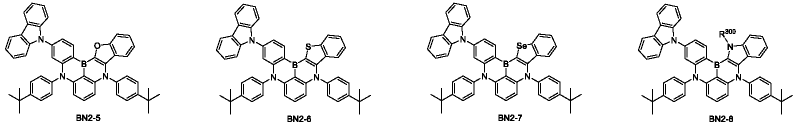

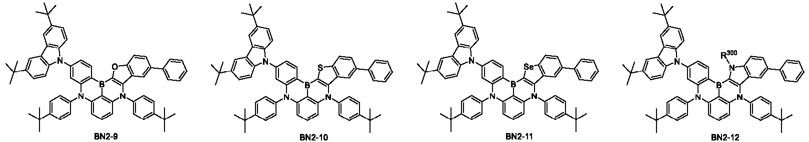

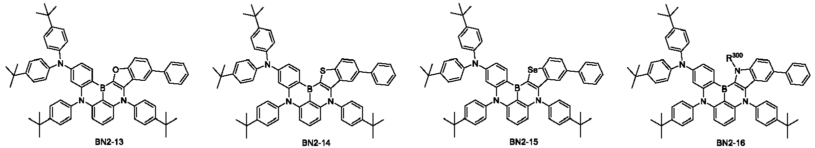

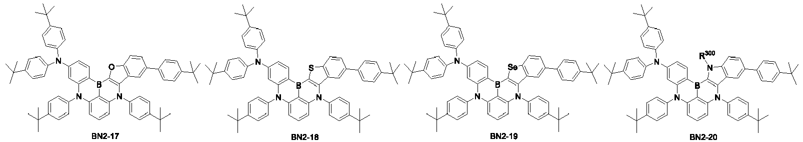

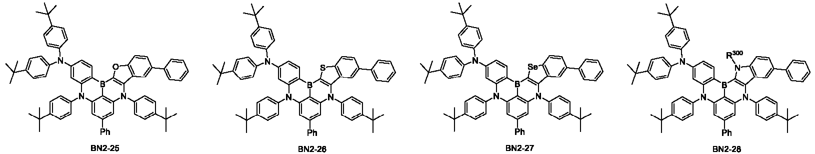

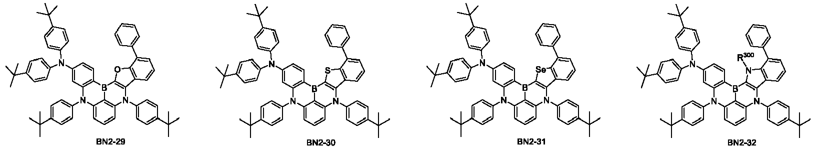

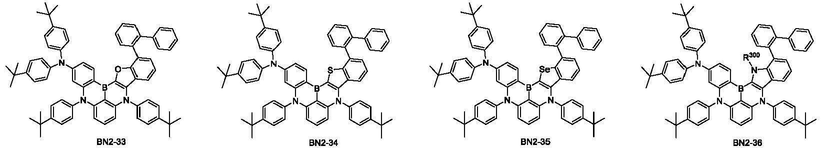

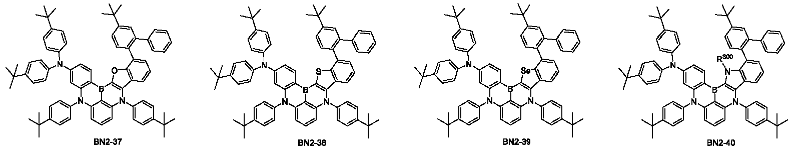

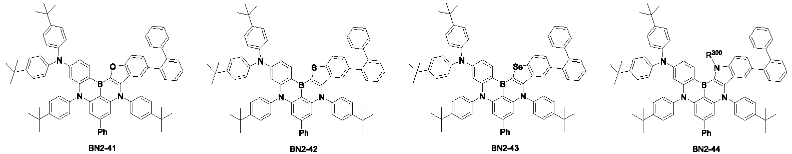

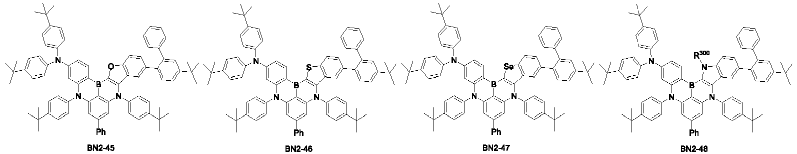

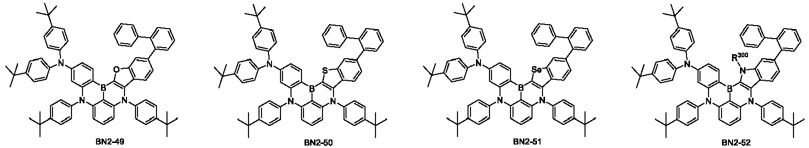

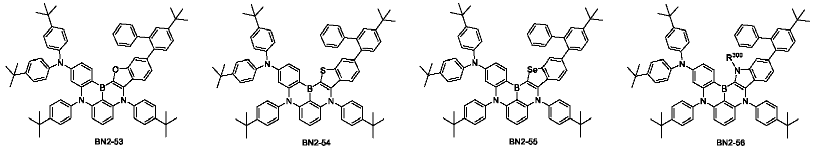

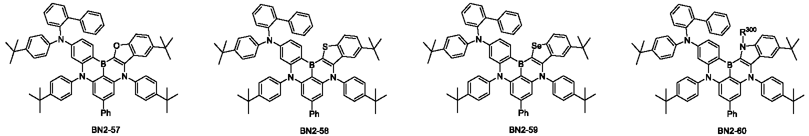

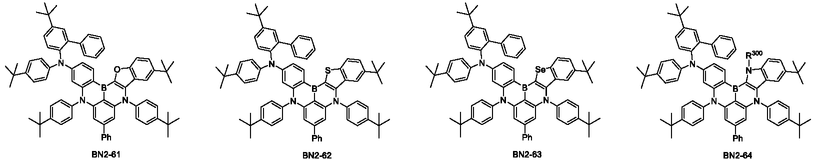

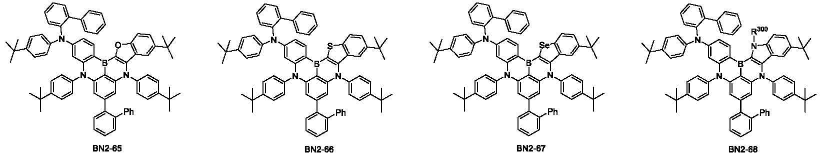

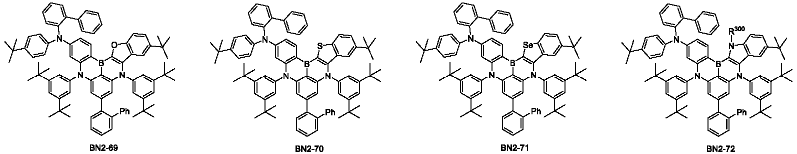

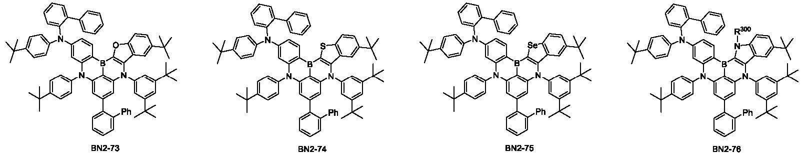

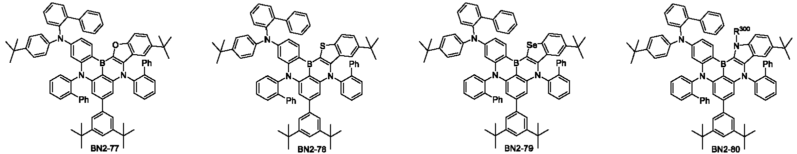

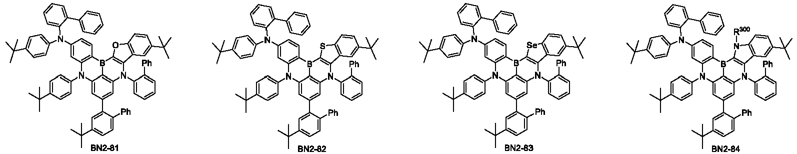

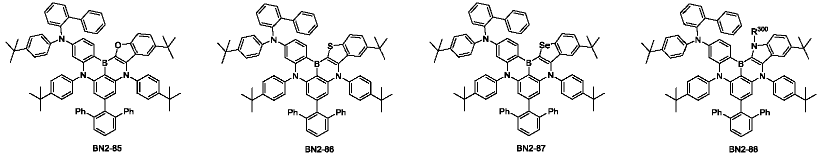

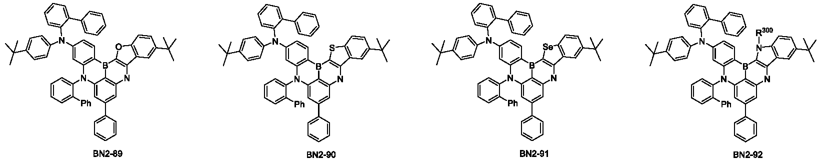

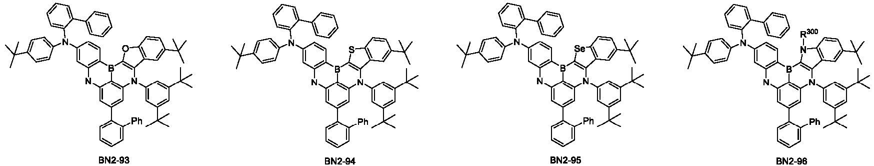

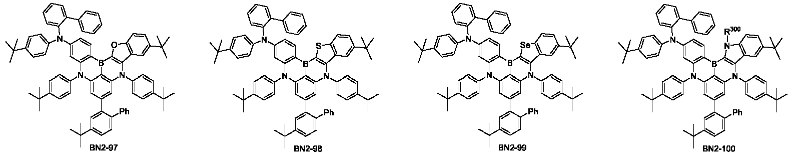

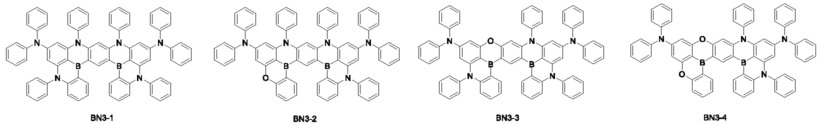

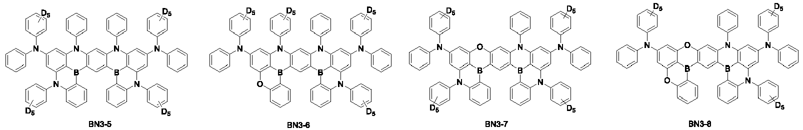

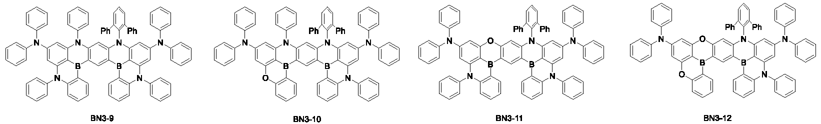

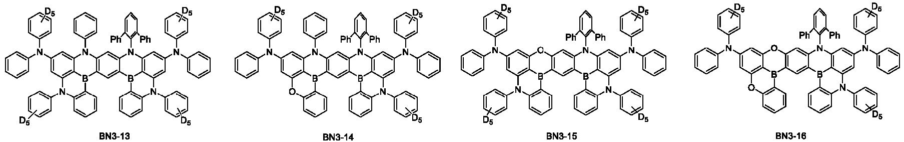

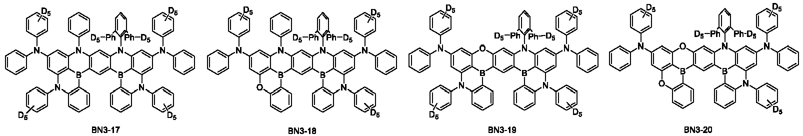

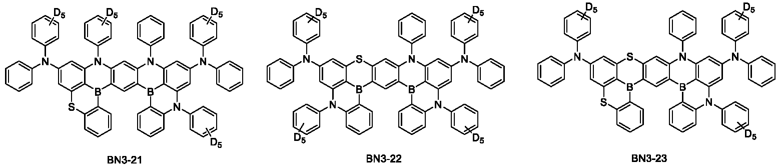

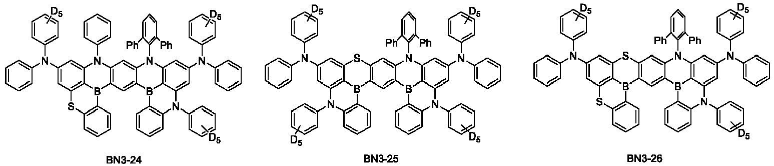

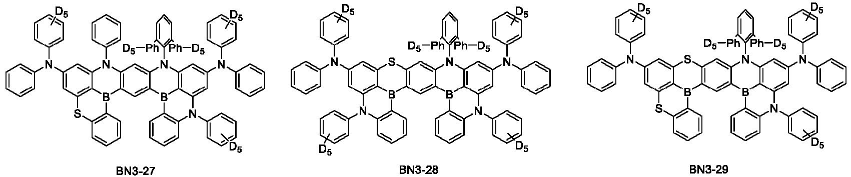

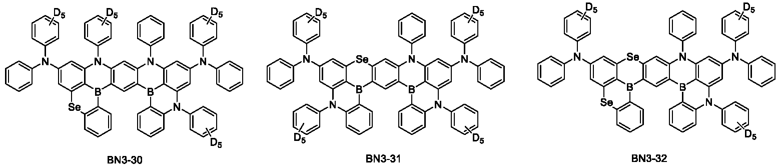

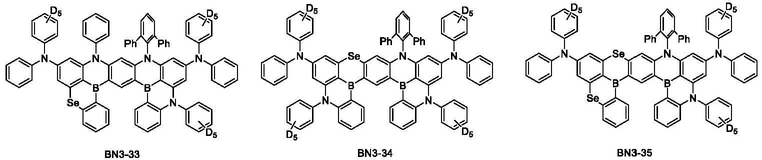

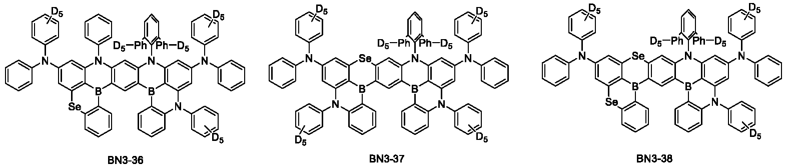

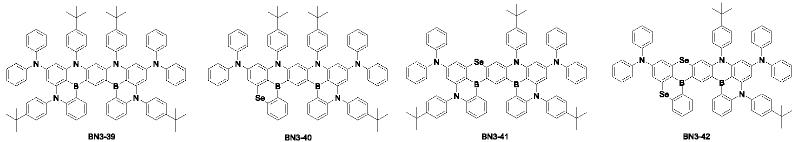

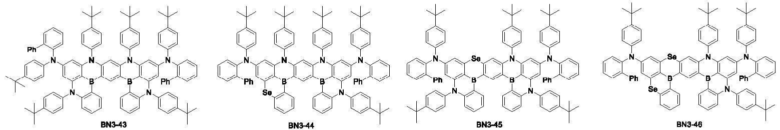

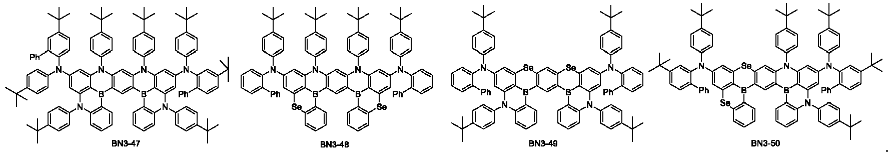

The metal platinum (II) complexes disclosed herein can exhibit desirable properties and have emission and/or absorption spectra that can be tuned by the selection of appropriate ligands.

The compounds of the disclosure can be prepared using a variety of methods, including but not limited to those described in the examples provided herein.

It is to be understood that both the foregoing general description and the following detailed description are exemplary and explanatory only and are not restrictive.

The present application can be understood more readily by reference to the following specific embodiments and the examples contained therein.

Before the present compounds, devices, and/or methods are disclosed and described, it is to be understood that they are not limited to specific synthetic methods (as otherwise indicated), or to specific reagents (as otherwise indicated), as such can, of course, vary. It is also to be understood that the terminology used herein is for the purpose of describing particular aspects only and is not intended to be limiting. Although any methods and materials similar or equivalent to those described herein can be used in the practice or testing, exemplary methods and materials are described below. All raw materials and solvents in the synthesis examples were commercially available unless otherwise specified, and the solvents were used directly without further treatment.

The substrate of the disclosure may be any substrate typically used in organic electronic devices. It may be a glass or transparent plastic substrate, it may be a substrate of an opaque material such as silicon or stainless steel, and it may be a flexible PI film. Different substrates have different mechanical strengths, thermal stability, transparency, surface smoothness, and water resistance, and the application direction is different according to the properties of the substrates. As the materials for the hole-injecting layer, the hole-transporting layer, and the electron-injecting layer, any material can be selected and used from known related materials for OLED devices, and the disclosure is not particularly limited thereto.

### Synthesis Example

The following examples of compound syntheses, compositions, devices, or methods are intended only to provide a general approach to the industry and are not intended to limit the scope of the patent. The data (amounts, temperatures, etc.) recited in the patent are to be as accurate as possible but may be subject to error. Unless otherwise specified, weighing is divided, the temperature is °C or normal temperature, and the pressure is near normal pressure.

Methods for the preparation of novel compounds are provided in the following examples, but the preparation of such compounds is not limited to this method. In this technical field, since the compounds protected in this patent are easily prepared by modification, they can be prepared by the methods listed below or by other methods. The following examples are given by way of example only and are not intended to limit the scope of this patent. The temperature, catalyst, concentration, reactants, and course of reaction may be varied to select different conditions for different reactants to produce the compound.

¹H NMR (500 MHz), ¹H NMR (400 MHz), and ¹³C NMR (126 MHz) spectra were measured on an ANANCE III (500M) NMR spectrometer; unless otherwise specified, DMSO-d₆ or CDCl₃ containing 0.1% TMS was used as the solvent for NMR, and TMS (δ = 0.00 ppm) is used as the internal standard when CDCl₃ is used as the solvent for ¹H NMR spectrum; when DMSO-d₆ was used as the solvent, TMS (δ = 0.00 ppm) or the residual DMSO peak (δ = 2.50 ppm) or the residual water peak (δ = 3.33 ppm) was used as the internal standard. In ¹³C NMR spectra, CDCl₃ (δ = 77.00 ppm) or DMSO-d₆ (δ = 39.52 ppm) was used as the internal standard. It was determined on an HPLC-MS Agilent 6210 TOF LC/MS type mass spectrometer; HRMS spectra were determined on an Agilent 6210 TOF LC/MS type liquid chromatography-time-of-flight mass spectrometer. In ¹H NMR spectral data: s = singlet, d = doublet, t = triplet, q = quartet, p = quintet, m = multiplet, br = broad.

### Synthetic route

### Example 1: The synthesis route of tetradentate cyclometallated platinum (II) complex Pt1 is as follows:

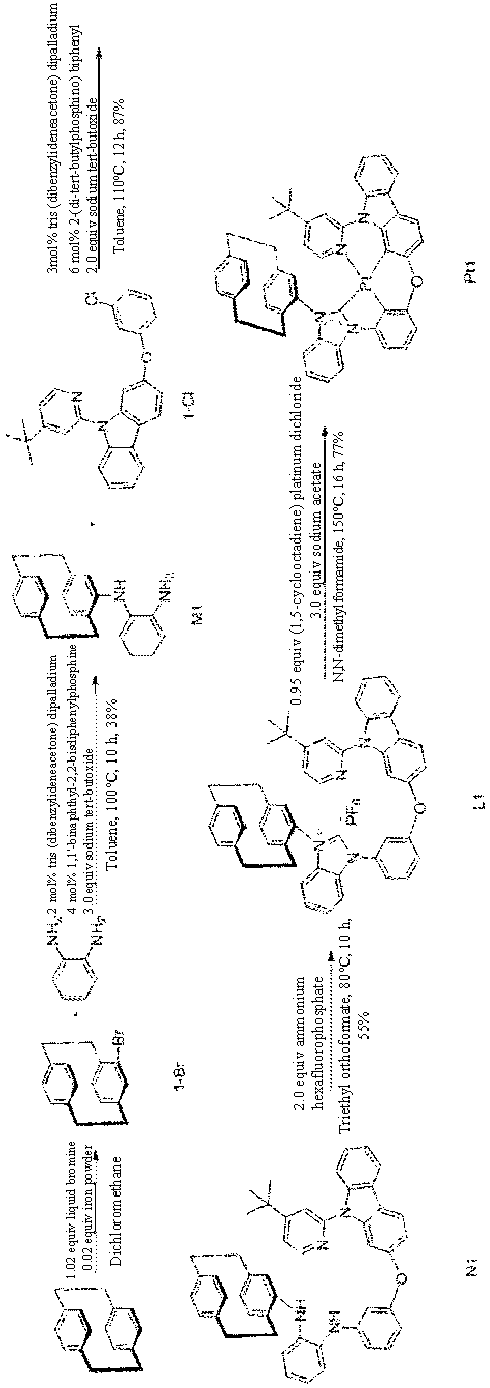

(1) Synthesis of intermediate 1-Br: Liquid bromine (3.77 mL, 73.45 mmol, 1.02 equiv) was dissolved with dichloromethane (80 mL), 5 mL of the above mixture and iron powder (80 mg, 1.44 mmol, 0.02 equiv) were successively added to a dried three-neck flask equipped with a magnetic rotor, and the reaction was stirred at room temperature for 1 h, and then dichloromethane (250 mL) and [2,2]paracyclophane (15 g, 72.01 mmol, 1.0 equiv) were successively added to the reaction solution. After the reaction was further stirred at room temperature for 30 min, a mixture of liquid bromine and dichloromethane (75 mL) was slowly added dropwise to the reaction solution. After the completion of the reaction monitored by TLC, saturated sodium thiosulfate solution was added for quenching, ethyl acetate was added for extraction, the aqueous layer was extracted three times with ethyl acetate, the organic phases were combined, dried over anhydrous sodium sulfate, filtered, and the solvent was distilled off under reduced pressure to give the product 1-Br as a white solid 21 g, which was directly used for the next reaction.
(2) Synthesis of intermediate M1: tris (dibenzylideneacetone) dipalladium (191 mg, 0.21 mmol, 0.03 equiv), 1,1'-binaphthyl-2,2'-bisdiphenylphosphine (260 mg, 0.42 mmol, 0.06 equiv), sodium tert-butoxide (2 g, 20.88 mmol, 3.0 equiv), 1,2-phenylenediamine (1.2 g, 11.14 mmol, 1.6 equiv), 1-Br (2 g, 6.96 mmol, 1.0 equiv) was successively added to a dried three-necked flask with a magnetic rotor, the mixture was purged with nitrogen three times, toluene (15 mL) was added under nitrogen protection, the mixture was stirred in an oil bath at 100°C for 10 h, cooled to room temperature, washed with water, extracted with ethyl acetate, the aqueous layer was extracted with ethyl acetate three times, the organic phases were combined, dried over anhydrous sodium sulfate, filtered and the solvent was distilled off under reduced pressure. The crude product obtained is purified by chromatography on a silica gel column with eluent: petroleum ether/dichloromethane = 1:1 to give product M1 as a yellow solid 840 mg, yield 38%. ¹H NMR (500 MHz, CDCl₃-*d*) : δ 2.67 - 2.74 (m, 1H), 2.83 - 2.90 (m, 1H), 2.98 - 3.14 (m, 6H), 3.82 (s, 2H), 5.14 (s, 1H), 5.61 (d, *J =* 1.5 Hz, 1H), 6.29 (dd, *J =* 7.5, 2.0 Hz, 1H), 6.39 - 6.45 (m, 2H), 6.48 (dd, *J* = 8.0, 2.0 Hz, 1H), 6.63 (dd, *J* = 8.0, 2.0 Hz, 1H), 6.76 (td, *J* = 7.5, 1.5 Hz, 1H), 6.84 (dd, *J* = 7.8, 1.5 Hz, 1H), 6.94 (td, *J =* 7.5, 1.5 Hz, 1H), 7.05 (dd, *J =* 8.0, 1.5 Hz, 1H), 7.14 (dd, *J* = 8.0, 2.0 Hz, 1H).
(3) Synthesis of intermediate N1: M1 (400 mg, 1.27 mmol, 1.0 equiv), 1-Cl (543 mg, 1.27 mmol, 1.0 equiv), tris (dibenzylideneacetone) dipalladium (35 mg, 0.04 mmol, 0.03 equiv), 2-(di-tert-butylphosphino) biphenyl (48 mg, 0.08 mmol, 0.06 equiv), sodium tert-butoxide (367 mg, 3.81 mmol, 3.0 equiv) were successively added to a dry Schlenk tube with magnetic rotor, the mixture was purged with nitrogen three times, toluene (8 mL) was added under nitrogen protection, and the mixture was placed in an oil bath at 110°C to stir the reaction for 12 h. The mixture was cooled to room temperature, washed with water, and extracted with ethyl acetate, the aqueous layer was extracted three times with ethyl acetate, the organic phases were combined, dried over anhydrous sodium sulfate, filtered, and the solvent was removed by distillation under reduced pressure. The crude product obtained is purified by chromatography on a silica gel column with eluent: petroleum ether/dichloromethane = 10:1 to give product N1 as a yellow solid 780 mg, yield 87%. (Note: the product obtained is unstable and needs to be put into the next step immediately after completing the column)
(4) Synthesis of ligand L1: N1 (705 mg, 1.0 mmol, 1.0 equiv) and ammonium hexafluorophosphate (326 mg, 2.0 mmol, 2.0 equiv) was successively added to a dry Schlenk tube with magnetic rotor. The mixture was purged with nitrogen three times. Triethyl orthoformate (4 mL) was added under nitrogen protection and the mixture was stirred in an oil bath at 80°C for 10 h. After completion of the reaction, it was cooled to room temperature and the solvent was distilled off under reduced pressure. The crude product obtained is purified by chromatography on a silica gel column with eluent: dichloromethane = 1:1 - dichloromethane-dichloromethane/ethyl acetate =50:1 to give product L1 as a purple solid 471 mg, yield 55%. ¹H NMR (500 MHz, DMSO-*d*₆): δ 1.34 (s, 9H), 2.72 - 2.77 (m, 1H), 2.82 - 2.88 (m, 1H), 2.93 - 2.98 (m, 1H), 3.05 - 3.22 (m, 5H), 6.68 - 6.74 (m, 2H), 6.77 (dd, *J* = 8.0, 2.0 Hz, 1H), 6.83 (dd, *J* = 8.0, 2.0 Hz, 1H), 6.88 (d, *J* = 7.5 Hz, 2H), 7.02 (s, 1H), 7.26 (dd, *J* = 8.5, 2.5 Hz, 1H), 7.36 (t, *J* = 7.5 Hz, 1H), 7.46 - 7.52 (m, 3H), 7.58 (d, *J* = 2.0 Hz, 1H), 7.66 (s, 1H), 7.72 (d, *J =* 1.5 Hz, 1H), 7.73 - 7.77 (m, 4H), 7.78 - 7.90 (m, 3H), 8.26 (d, *J* = 7.5 Hz, 1H), 8.36 (d, *J =* 8.5 Hz, 1H), 8.61 (d, *J =* 5.5 Hz, 1H), 10.45 (s, 1H).
(5) Synthesis of Pt1: L1 (200 mg, 0.23 mmol, 1.0 equiv), platinum (1,5-cyclooctadiene) dichloride (83 mg, 0.22 mmol, 0.95 equiv), and sodium acetate (57 mg, 0.69 mmol, 3.0 equiv) were successively added to a dry sealed tube with a magnetic rotor, followed by purged with nitrogen three times. N,N-dimethylformamide (7 mL) was added under nitrogen protection. After nitrogen bubbling was performed for 30 min, the sealed tube was completely wrapped with aluminum foil paper to protect it from light. The mixture was placed in a 150°C oil bath and stirred for 16 h. The mixture was cooled to room temperature, and deionized water was added and stirred for 5-10 min to quench. Ethyl acetate was added for extraction. The aqueous layer was extracted three times with ethyl acetate. The organic phases were combined, dried over anhydrous sodium sulfate, and filtered, and the solvent was removed by distillation under reduced pressure. The crude product obtained is purified by chromatography on a silica gel column with eluent: petroleum ether/dichloromethane = 1:1 to give product Pt1 as a yellow solid 163 mg, yield 77%. ¹H NMR (500 MHz, CDCl₃-*d*): δ 1.13 (d, *J =* 2.5 Hz, 9H), 2.56 - 2.66 (m, 2H), 2.77 - 2.83 (m, 1H), 3.07 - 3.22 (m, 3H), 3.31 - 3.42 (m, 2H), 5.89 -5.91 (m, 1H), 5.97 (d, *J* = 7.5 Hz, 1H), 6.19 (d, *J* = 7.5 Hz, 1H), 6.22 (dd, *J* = 7.5 Hz, 2.0 Hz, 1H), 6.58 (dd, *J* = 7.5 Hz, 1.5 Hz, 1H), 6.67 - 6.72 (m, 2H), 7.12 (t, *J* = 4.0 Hz, 1H), 7.19 (d, *J* = 7.5, 1H), 7.34 - 7.40 (m, 2H), 7.42 - 7.26 (m, 2H), 7.56 - 7.64 (m, 2H), 7.63 (dd, *J =* 7.0, 2.5 Hz, 1H), 7.82 - 7.84 (m, 2H), 7.87 (d, *J* = 8.0 Hz, 1H), 8.08 (dd, *J* = 7.5, 1.5 Hz, 1H), 8.17 (d, *J* = 6.5 Hz, 1H), 8.20 - 8.22 (m, 1H), 8.28 - 8.30 (m, 1H).

### Example 2: The synthesis route of tetradentate cyclometallated platinum (II) complex Pt2 is as follows:

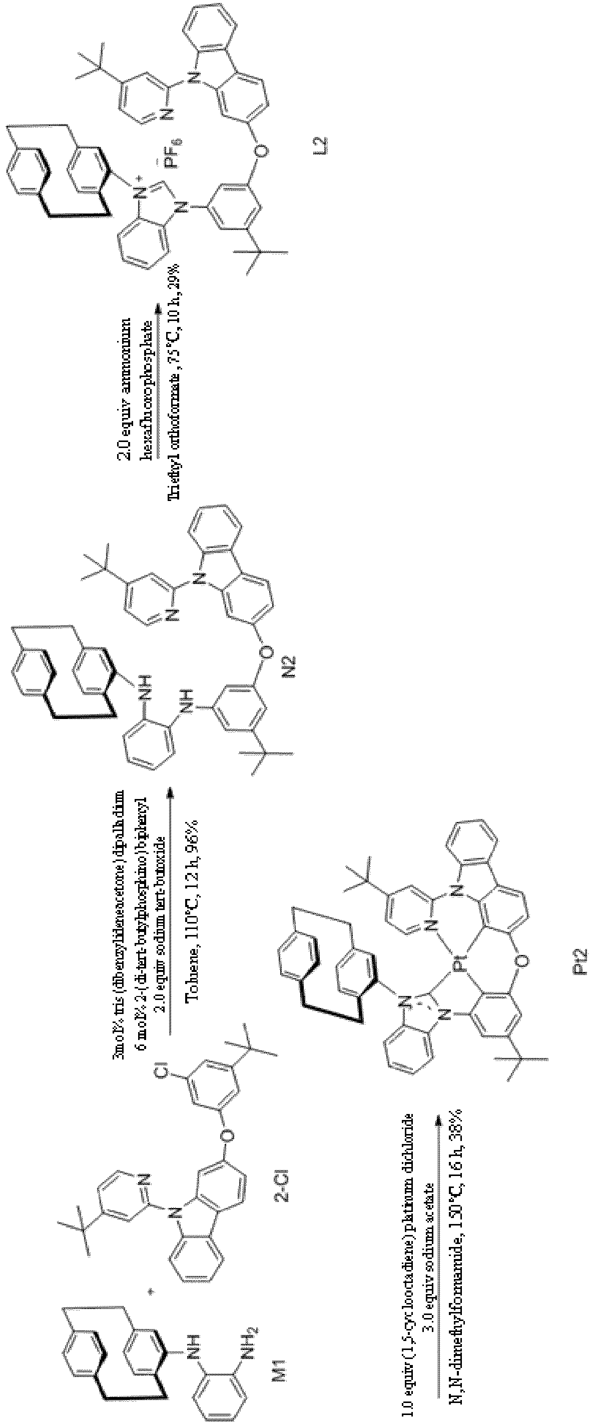

(1) Synthesis of intermediate N2: M1 (200 mg, 0.64 mmol, 1.0 equiv), 2-Cl (309 mg, 0.64 mmol, 1.0 equiv), tris (dibenzylideneacetone) dipalladium (18 mg, 0.02 mmol, 0.03 equiv), 2-(di-tert-butylphosphino) biphenyl (24 mg, 0.04 mmol, 0.06 equiv), sodium tert-butoxide (123 mg, 1.28 mmol, 2.0 equiv) were successively added to a dry Schlenk tube with a magnetic rotor, the mixture was purged with nitrogen three times, toluene (6 mL) was added under nitrogen protection, and the mixture was placed in an oil bath at 110°C to stir the reaction for 12 h. The mixture was cooled to room temperature, washed with water, and extracted with ethyl acetate, the aqueous layer was extracted three times with ethyl acetate, the organic phases were combined, dried over anhydrous sodium sulfate, filtered, and the solvent was removed by distillation under reduced pressure. The crude product obtained is purified by chromatography on a silica gel column with eluent: petroleum ether/dichloromethane = 20:1 to give product N2 as a yellow solid 460 mg, yield 96%. (Note: the product obtained is unstable and needs to be put into the next step immediately after completing the column)
(2) Synthesis of ligand L2: N2 (430 mg, 0.57 mmol, 1.0 equiv) and ammonium hexafluorophosphate (186 mg, 1.14 mmol, 2.0 equiv) was successively added to a dry Schlenk tube with magnetic rotor. The mixture was purged with nitrogen three times. Triethyl orthoformate (4 mL) was added under nitrogen protection and the mixture was stirred in an oil bath at 75 °C for 10 h. After completion of the reaction, it was cooled to room temperature, and the solvent was distilled under reduced pressure. The crude product obtained is purified by chromatography on a silica gel column with eluent: dichloromethane = 1:1 - dichloromethane-dichloromethane/ethyl acetate =50:1 to give product L2 as a gray solid 150 mg, yield 29%. ¹H NMR (500 MHz, CDCl₃-*d*) δ 1.39 (s, 9H), 1.43 (s, 9H), 258 - 2.64 (m, 1H), 2.78 - 2.83 (m, 1H), 2.87 - 2.94 (m, 1H), 3.02 - 3.06 (m, 1H), 3.13 (d, *J* = 11.0 Hz, 2H), 3.39 (d, *J* = 9.0 Hz, 2H), 6.49 (d, *J* = 9.0 Hz, 1H), 6.62 (dd, *J* = 7.5, 2.0 Hz, 1H), 6.73 - 6.76 (m, 2H), 6.82 (dd, *J* = 7.5, 1.5 Hz, 1H), 6.90 (d, *J* = 8.0 Hz, 1H), 7.10 (t, *J* = 2.0 Hz, 1H), 7.19 (dd, *J* = 8.5, 2.0 Hz, 1H), 7.25 (d, *J* = 1.5 Hz, 1H), 7.31 (d, J = 7.5 Hz, 1H), 7.32 - 7.33 (m, 1H), 7.41 - 7.45 (m, 1H), 7.49 (t, *J =* 2.0 Hz, 1H), 7.52 - 7.54 (m, 1H), 7.59 - 7.67 (m, 4H), 7.68 (d, *J =* 8.0 Hz, 1H), 7.70 (d, *J* = 2.0 Hz, 1H), 7.74 (d, *J* = 8.0 Hz, 1H), 8.08 (d, *J* = 7.5 Hz, 1H), 8.13 (d, *J =* 8.5 Hz, 1H), 8.59 (d, *J* = 5.5 Hz, 1H), 9.55 (s, 1H).
(3) Synthesis of Pt2: L2 (130 mg, 0.14 mmol, 1.0 equiv), platinum (1,5-cyclooctadiene) dichloride (52 mg, 0.14 mmol, 1.0 equiv), and sodium acetate (34 mg, 0.42 mmol, 3.0 equiv) were successively added to a dry sealed tube with a magnetic rotor, followed by purged with nitrogen three times. N,N-dimethylformamide (6 mL) was added under nitrogen protection. After nitrogen bubbling was performed for 30 min, the sealed tube was completely wrapped with aluminum foil paper to protect it from light. The mixture was placed in a 150°C oil bath and stirred for 16 h. The mixture was cooled to room temperature, and deionized water was added and stirred for 5-10 min to quench. Ethyl acetate was added for extraction. The aqueous layer was extracted three times with ethyl acetate. The organic phases were combined, dried over anhydrous sodium sulfate, and filtered, and the solvent was removed by distillation under reduced pressure. The crude product obtained is purified by chromatography on a silica gel column with eluent: petroleum ether/dichloromethane = 1:1 to give product Pt2 as a yellow solid 48 mg, yield 38%. ¹H NMR (500 MHz, CDCl₃-*d*) δ 1.15 (d, *J= 1.0* Hz, 9H), 1.52 (s, 9H), 2.57 - 2.60 (m, 2H), 2.77 - 2.80 (m, 1H), 3.06 - 3.18 (m, 3H), 3.29 - 3.41 (m, 2H), 5.93 (dt, *J* = 6.5, 1.0 Hz, 1H), 5.96 (d, *J =* 8.0 Hz, 1H), 6.18 - 6.21 (m, 2H), 6.57 (dd, *J* = 8.0, 2.0 Hz, 1H), 6.66 - 6.70 (m, 2H), 7.12 (s, 1H), 7.22 (d, *J* = 1.5 Hz, 1H), 7.35 - 7.47 (m, 3H), 7.54 - 7.60 (m, 2H), 7.70 (d, *J* = 2.0 Hz, 1H), 7.81 (d, *J* = 8.0 Hz, 1H), 7.83 (s, 1H), 7.87 (d, *J =* 8.0 Hz, 1H), 8.04 - 8.08 (m, 1H), 8.15 (d, *J* = 6.0 Hz, 1H), 8.20 - 8.22 (m, 1H), 8.27 (d, *J* = 8.0 Hz, 1H).

### Example 3: Tetradentate cyclometallated platinum (II) complex Pt3

The synthetic route is as follows:

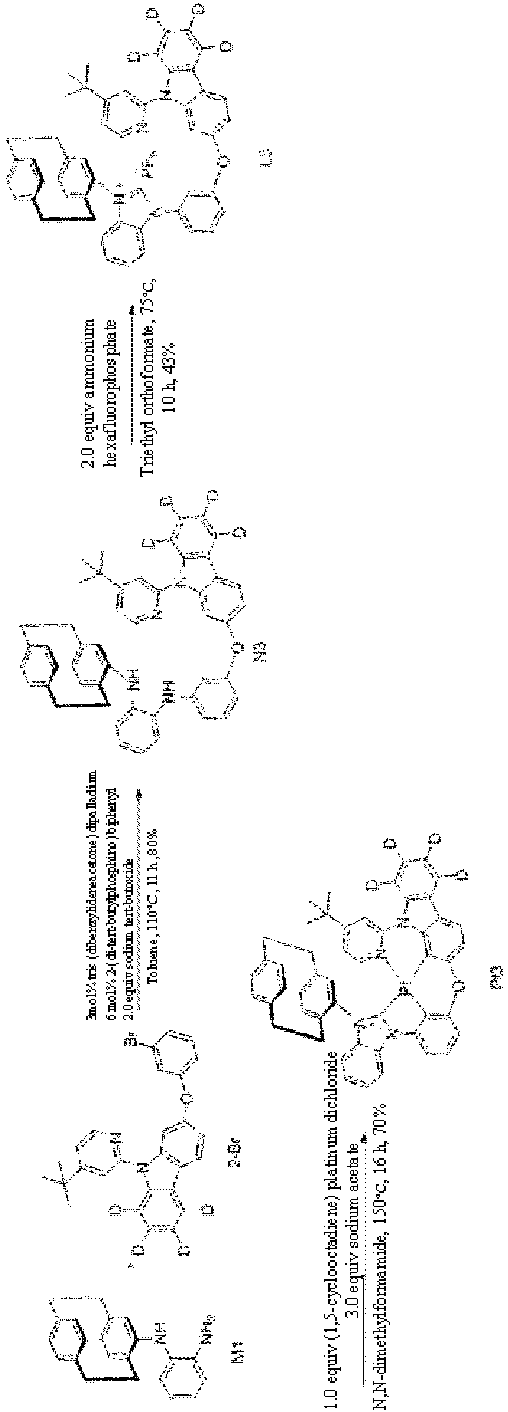

Pt3 was synthesized with reference to the synthesis procedure and reaction conditions of compound Pt1. The final product Pt3 was prepared as a yellow solid 230 mg in 70% yield. ¹H NMR (500 MHz, CDCl₃-*d*) δ 1.07 (s, 9H), 2.53 - 2.64 (m, 2H), 2.74 - 2.79 (m, 1H), 3.06 - 3.17 (m, 3H), 3.29 - 3.41 (m, 2H), 5.82 (dd, *J* = 6.0, 2.0 Hz, 1H), 5.92 (d, *J* = 8.0 Hz, 1H), 6.15 (dd, *J* = 8.0, 1.5 Hz, 1H), 6.19 (dd, *J* = 8.0, 2.0 Hz, 1H), 6.56 (dd, *J* = 8.0, 2.0 Hz, 1H), 6.65 - 6.70 (m, 2H), 7.06 (d, *J=* 1.5 Hz, 1H), 7.18 (dd, *J* = 8.0, 1.0 Hz, 1H), 7.34 (t, *J =* 7.5 Hz, 1H), 7.41 (d, *J =* 8.0 Hz, 1H), 7.55 - 7.57 (m, 3H), 7.76 (d, *J* = 2.0 Hz, 1H), 7.82 (d, *J =* 8.0 Hz, 1H), 8.14 (d, *J* = 6.0 Hz, 1H), 8.17 - 8.19 (m, 1H), 8.24 - 8.25 (m, 1H).

### Example 4: The synthesis route of tetradentate cyclometallated platinum (II) complex Pt4 is as follows:

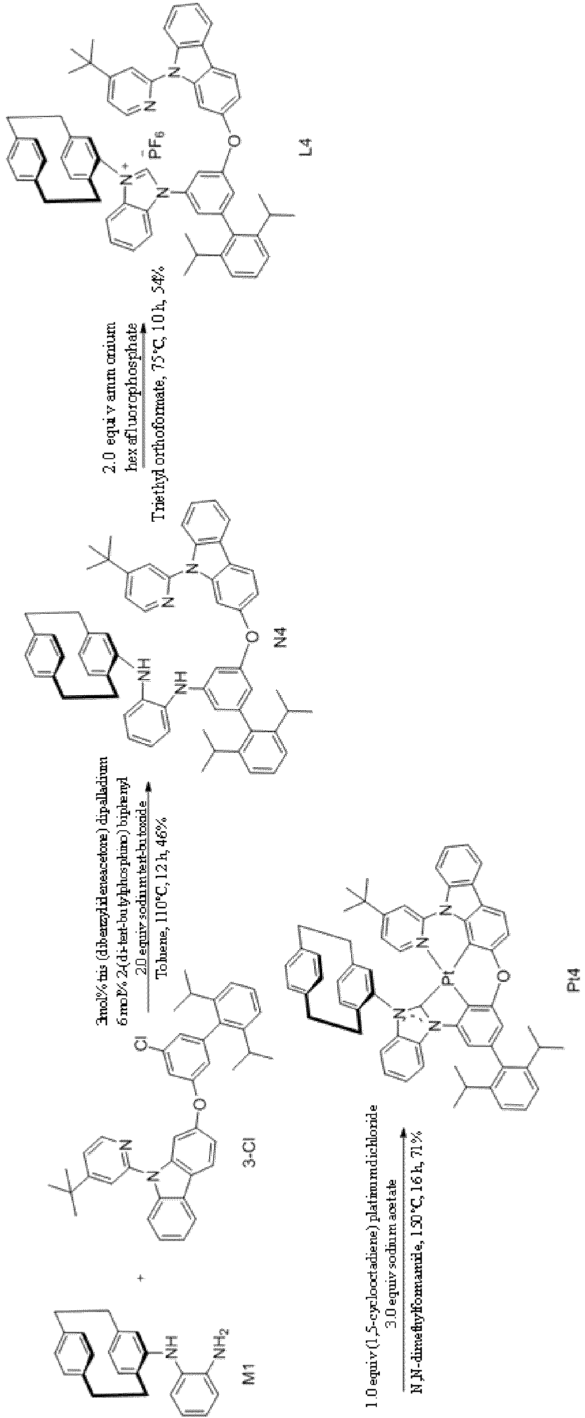

Pt4 was synthesized with reference to the synthesis procedure and reaction conditions of compound Pt1. The final product Pt4 was prepared as a yellow solid 240 mg in 71% yield. ¹H NMR (500 MHz, CDCl₃-*d*) : δ 1.16 (d, *J =* 7.0 Hz, 6H), 1.20 (t, *J =* 5.5 Hz, 14H), 2.61 - 2.71 (m, 2H), 2.82 - 2.87 (m, 1H), 3.01 - 3.17 (m, 4H), 3.22 - 3.29 (m, 1H), 3.32 - 3.43 (m, 2H), 5.99 - 6.02 (m, 2H), 6.23 (d, *J* = 8.0 Hz, 2H), 6.61 (dd, *J* = 7.5, 1.5 Hz, 1H), 6.69 (d, *J* = 7.5 Hz, 1H), 6.73 (dd, *J* = 7.5 Hz, 1.5 Hz, 1H), 7.01 (d, *J* = 1.0 Hz, 1H), 7.16 (s, 1H), 7.30 - 7.32 (m, 2H), 7.39 - 7.52 (m, 6H), 7.56 (t, *J* = 7.5 Hz, 1H), 7.85 (d, *J =* 8.0 Hz, 1H), 7.90 (d, *J* = 2.0 Hz, 1H), 7.92 (d, *J* = 8.0 Hz, 1H), 8.10 (d, *J* = 7.5 Hz, 1H), 8.18 (d, *J* = 8.0 Hz, 1H), 8.21 (d, *J* = 6.5 Hz, 1H), 8.23 (d, *J* = 8.0 Hz, 1H).

### Example 5: Synthesis of Pt74

Pt74 was synthesized with reference to the synthesis procedure and reaction conditions of compound Pt1. The desired product was obtained as a yellow solid 274 mg, yield 63%, molecular weight [M+H]+: 1136.41.

### Example 6: Synthesis of Pt77

Pt77 was synthesized with reference to the synthesis procedure and reaction conditions of compound Pt1. The desired product was obtained as a yellow solid 321 mg, yield 74%, molecular weight [M+H]+: 1082.42.

### Example 7: Synthesis of Pt88

Pt88 was synthesized by referring to the synthesis procedure and reaction condition of compound Pt1. The desired product was obtained as a yellow solid 308 mg, yield 69%, molecular weight [M+H]+: 976.29.

### Example 8: Synthesis of Pt89

Pt89 was synthesized with reference to the synthesis procedure and reaction conditions of compound Pt1. The desired product was obtained as a yellow solid 210 mg in 69% yield. Molecular weight [M+H]+: 984.33.

### Example 9: Synthesis of Pt90

Pt90 was synthesized with reference to the synthesis procedure and reaction conditions of compound Pt1. The desired product was obtained as a yellow solid 310 mg in 67% yield. Molecular weight [M+H]+: 1068.42.

### Example 10: Synthesis of Pt91

Pt91 was synthesized with reference to the synthesis procedure and reaction conditions of compound Pt1. The desired product was obtained as a yellow solid 237 mg in 72% yield. Molecular weight [M+H]+: 1020.43.

### Example 11: Synthesis of Pt92

Pt92 was synthesized with reference to the synthesis procedure and reaction conditions of compound Pt1. The desired product was obtained as a yellow solid 362 mg in 70% yield. Molecular weight [M+H]+: 1012.38.

### Example 12: Synthesis of Pt93

Pt93 was synthesized with reference to the synthesis procedure and reaction conditions of compound Pt1. The desired product was obtained as a yellow solid 410 mg in 68% yield. Molecular weight [M+H]+: 1026.36.

### Example 13: Synthesis of Pt94

Pt94 was synthesized with reference to the synthesis procedure and reaction conditions of compound Pt1. The desired product was obtained as a yellow solid 320 mg in 74% yield. Molecular weight [M+H]+: 1096.44.

### Example 14: Synthesis of Pt95

Pt95 was synthesized with reference to the synthesis procedure and reaction conditions of compound Pt1. The desired product was obtained as a yellow solid 236 mg in 73% yield. Molecular weight [M+H]+: 1026.38.

### Example 15: Synthesis of Pt96

Pt96 was synthesized with reference to the synthesis procedure and reaction conditions of compound Pt1. The desired product was obtained as a yellow solid 279 mg in 71% yield. Molecular weight [M+H]+: 1034.45.

### Example 16: Synthesis of Pt97

Pt97 was synthesized with reference to the synthesis procedure and reaction conditions of compound Pt1. The desired product was obtained as a yellow solid 318 mg in 70% yield. Molecular weight [M+H]+: 970.31.

### Example 17: Synthesis of Pt98

Pt98 was synthesized with reference to the synthesis procedure and reaction conditions of compound Pt1. The desired product was obtained as a yellow solid 256 mg in 69% yield. Molecular weight [M+H]+: 976.28.

### Example 18: Synthesis of Pt99

Pt99 was synthesized with reference to the synthesis procedure and reaction conditions of compound Pt1. The desired product was obtained as a yellow solid 374 mg in 77% yield. Molecular weight [M+H]+: 954.37.

### Example 19: Synthesis of Pt100

Pt100 was synthesized with reference to the synthesis procedure and reaction conditions of compound Pt1. The desired product was obtained as a yellow solid 269 mg in 71% yield. Molecular weight [M+H]+: 1124.49. Example 20: Synthesis of Pt147

Pt147 was synthesized with reference to the synthesis procedure and reaction conditions of compound Pt1. The desired product was obtained as a yellow solid 247 mg, yield 75%, molecular weight [M+H]+: 996.42.

### Example 21: Synthesis of Pt149

Pt149 was synthesized with reference to the synthesis procedure and reaction conditions of compound Pt1. The desired product was obtained as a yellow solid 368 mg, yield 78%, molecular weight [M+H]+: 1032.35.

### Example 22: Synthesis of Pt160

Pt160 was synthesized with reference to the synthesis procedure and reaction conditions of compound Pt1. The desired product was obtained as a yellow solid 321 mg, yield 67%, molecular weight [M+H]+: 1132.55.

### Example 23: Synthesis of Pt168

Pt168 was synthesized with reference to the synthesis procedure and reaction conditions of compound Pt1. The desired product was obtained as a yellow solid 301 mg, yield 59%, molecular weight [M+H]+: 1026.39.

### Example 24: Synthesis of Pt177

Pt177 was synthesized with reference to the synthesis procedure and reaction conditions of compound Pt1. The desired product was obtained as a yellow solid 311 mg, yield 70%, molecular weight [M+H]+: 998.32.

### Example 25: Synthesis of Pt211

Pt211 was synthesized with reference to the synthesis procedure and reaction conditions of compound Pt1. The desired product was obtained as a yellow solid 337 mg, yield 72%, molecular weight [M+H]+: 960.30.

### Example 26: Synthesis of Pt224

Pt224 was synthesized with reference to the synthesis procedure and reaction conditions of compound Pt1. The desired product was obtained as a yellow solid 295 mg, yield 76%, molecular weight [M+H]+: 1063.48.

### Example 27: Synthesis of Pt227

Pt227 was synthesized with reference to the synthesis procedure and reaction conditions of compound Pt1. The desired product was obtained as a yellow solid 302 mg, yield 71%, molecular weight [M+H]+: 1050.37.

### Example 28: Synthesis of Pt238

Pt238 was synthesized with reference to the synthesis procedure and reaction conditions of compound Pt1. The desired product was obtained as a yellow solid 307 mg, yield 62%, molecular weight [M+H]+: 1054.42.

### Example 29: Synthesis of Pt259

Pt259 was synthesized with reference to the synthesis procedure and reaction conditions of compound Pt1. The desired product was obtained as a yellow solid 284 mg, yield 68%, molecular weight [M+H]+: 917.36.

### Example 30: Synthesis of Pt260

Pt260 was synthesized with reference to the synthesis procedure and reaction conditions of compound Pt1. The desired product was obtained as a yellow solid 315 mg, yield 77%, molecular weight [M+H]+: 1228.55.

### Example 31: Synthesis of Pt263

Pt263 was synthesized with reference to the synthesis procedure and reaction conditions of compound Pt1. The desired product was obtained as a yellow solid 317 mg, yield 70%, molecular weight [M+H]+: 1340.68.

### Example 32: Synthesis of Pt268

Pt268 was synthesized with reference to the synthesis procedure and reaction conditions of compound Pt1. The desired product was obtained as a yellow solid 344 mg, yield 65%, molecular weight [M+H]+: 1268.49.

### Example 33: Synthesis of Pt275

Pt275 was synthesized with reference to the synthesis procedure and reaction conditions of compound Pt1. The desired product was obtained as a yellow solid 251 mg, yield 76%, molecular weight [M+H]+: 1038.46.

### Example 34: Synthesis of Pt281

Pt281 was synthesized with reference to the synthesis procedure and reaction conditions of compound Pt1. The desired product was obtained as a yellow solid 367 mg, yield 61%, molecular weight [M+H]+: 1138.51.

### Example 35: Synthesis of Pt287

Pt287 was synthesized with reference to the synthesis procedure and reaction conditions of compound Pt1. The desired product was obtained as a yellow solid 354 mg, yield 72%, molecular weight [M+H]+: 1152.50.

### Example 36: Synthesis of Pt307

Pt307 was synthesized with reference to the synthesis procedure and reaction conditions of compound Pt1. The desired product was obtained as a yellow solid 327 mg, yield 70%, molecular weight [M+H]+: 1128.51.

### Example 37: Synthesis of Pt310

Pt310 was synthesized with reference to the synthesis procedure and reaction conditions of compound Pt1. The desired product was obtained as a yellow solid 298 mg, yield 64%, molecular weight [M+H]+: 1152.50.

### Example 38: Synthesis of Pt320

Pt320 was synthesized with reference to the synthesis procedure and reaction conditions of compound Pt1. The desired product was obtained as a yellow solid 330 mg, yield 73%, molecular weight [M+H]+: 1110.47.

### Theoretical calculation description

The geometry of the ground state (S₀) molecule was optimized by density functional theory (DFT). DFT calculations were performed using B3LYP functional where the 6-31G (d) basis set was used for C, H, O, and N atoms and the LANL2DZ basis set was used for Pt atoms.

**Table 1: Frontier orbital energy level of partial metal complexes**

| Metal complexes | LUMO/eV | HOMO /eV | Gap/eV |
|---|---|---|---|
| Pt1 | 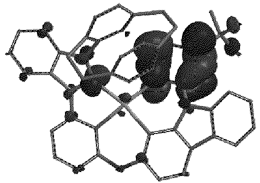 -1.34 eV | 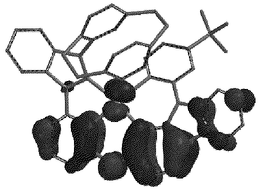 -4.68 eV | 3.34 eV |
| Pt2 | 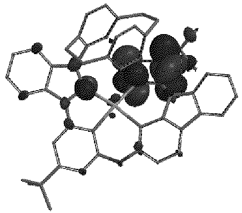 -1.33 eV | 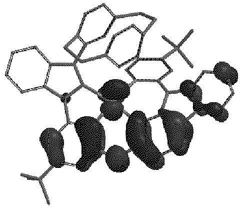 -4.64 eV | 3.31 eV |
| Pt4 | 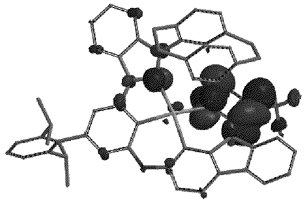 -1.39 eV | 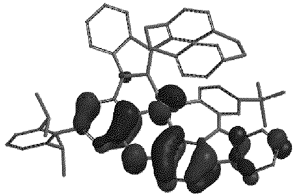 -4.73 eV | 3.34 eV |

### Photophysical properties:

**Table 2. Photophysical property data of some metal complexes in dichloromethane solution**

| **Complexes** | **Maximum emission wavelength** | **Half peak width** |
|---|---|---|
| Pt1 | 458 nm | 41 nm |
| Pt2 | 463 nm | 48 nm |
| Pt3 | 457 nm | 26 nm |
| Pt4 | 461 nm | 37 nm |

### Fabrication of OLED devices:

As a reference preparation method for a device embodiment, the disclosure evaporates a p-doped material on the surface or the anode of an ITO glass with a light-emitting area of 2 mm × 2 mm or co-evaporates the p-doped material with a hole injection material at a concentration of 1%-50% to form a hole injection layer (HIL) of 5-100 nm, a hole transport layer (HTL) of 5-200 nm, then forms a light-emitting layer (EML) of 10-100 nm (which may contain the compound described in the disclosure) on the hole transport layer, and forms an electron transport layer (ETL) of 20-200 nm and a cathode of 50-200 nm; if necessary, an electron-blocking layer (EBL) is added between the HTL and EML layers, and an electron-injecting layer (EIL) is added between the ETL and the cathode to fabricate a OLED device. The OLED was tested by standard methods. The device materials referred to in the disclosure may be obtained by known synthetic methods unless otherwise specified.

In a preferred embodiment, the structure of Device Example 1 provided by the disclosure is ITO/P-4 (10 nm)/NPD (60 nm)/HTH-85 (5 nm)/platinum (II) complex Pt1: HTH-85:ETH-45 (25 nm) (mass ratio of Pt1:HTH-85:ETH-45 is 10:60:30)/ETH-5 (5 nm)/ET-14 (40 nm)/LiQ (1 nm)/Al (100 nm).

Device Example 2 - Device Example 38 and Comparative Example 1 were each prepared using a structure similar to that of Device Example 1, except that Pt-1 in Device Example 1 was replaced with the complexes in Table 3, respectively. The comparative examples and each Device Example prepared above were tested for light-emitting characteristics by standard methods, and the data are shown in Table 3. The structural formula of the device concerned is as follows: Wherein P-4 is HATCN, and ET-14 is BPyTP.

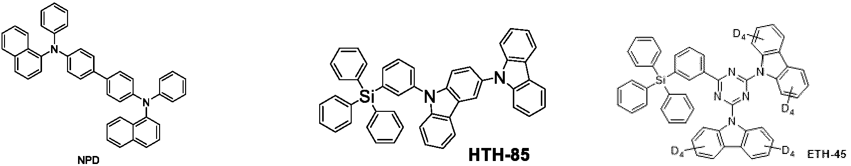

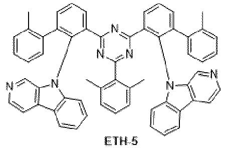

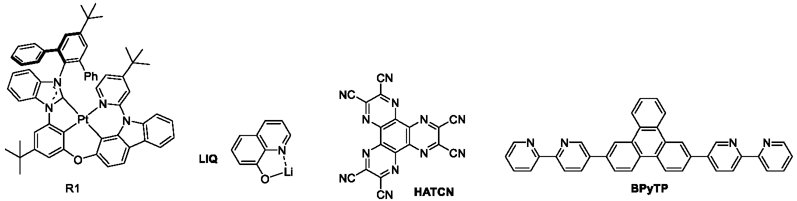

**Table 3. Device light-emitting characteristics data table**

| Examples | Complexes | Driving voltage (Volts)@10mA/cm² (Relative value, %) | Current efficiency (cd/A) @1000 cd/m² (Relative value, %) | Device lifetime (h) @1000 cd/m² (Relative value, %) |
|---|---|---|---|---|
| Comparative Example 1 | R1 | 100 | 100 | 100 |
| Device Example 1 | Pt1 | 97 | 118 | 123 |
| Device Example 2 | Pt2 | 96 | 117 | 120 |
| Device Example 3 | Pt3 | 97 | 116 | 124 |
| Device Example 4 | Pt4 | 96 | 119 | 122 |
| Device Example 5 | Pt74 | 96 | 121 | 124 |
| Device Example 6 | Pt77 | 96 | 119 | 126 |
| Device Example 7 | Pt88 | 97 | 118 | 124 |
| Device Example 8 | Pt89 | 98 | 116 | 123 |
| Device Example 9 | Pt90 | 97 | 119 | 124 |
| Device Example 10 | Pt91 | 97 | 118 | 124 |
| Device Example 11 | Pt92 | 98 | 117 | 124 |
| Device Example 12 | Pt93 | 96 | 119 | 126 |
| Device Example 13 | Pt94 | 98 | 120 | 120 |
| Device Example 14 | Pt95 | 97 | 120 | 122 |
| Device Example 15 | Pt96 | 97 | 119 | 125 |
| Device Example 16 | Pt97 | 97 | 120 | 128 |
| Device Example 17 | Pt98 | 96 | 123 | 129 |
| Device Example 18 | Pt99 | 96 | 121 | 128 |
| Device Example 19 | Pt100 | 96 | 121 | 126 |
| Device Example 20 | Pt147 | 97 | 120 | 129 |
| Device Example 21 | Pt149 | 97 | 120 | 126 |
| Device Example 22 | Pt160 | 98 | 118 | 124 |
| Device Example 23 | Pt168 | 98 | 116 | 127 |
| Device Example 24 | Pt177 | 96 | 121 | 128 |
| Device Example 25 | Pt211 | 96 | 126 | 128 |
| Device Example 26 | Pt224 | 97 | 121 | 127 |
| Device Example 27 | Pt227 | 97 | 124 | 127 |
| Device Example 28 | Pt23 8 | 98 | 123 | 126 |
| Device Example 29 | Pt259 | 97 | 122 | 125 |
| Device Example 30 | Pt560 | 96 | 120 | 128 |
| Device Example 31 | Pt263 | 96 | 121 | 127 |
| Device Example 32 | Pt268 | 96 | 121 | 129 |
| Device Example 33 | Pt275 | 97 | 118 | 125 |
| Device Example 34 | Pt281 | 97 | 120 | 126 |
| Device Example 35 | Pt287 | 96 | 122 | 125 |
| Device Example 36 | Pt307 | 97 | 118 | 126 |
| Device Example 37 | Pt310 | 97 | 120 | 128 |
| Device Example 38 | Pt320 | 97 | 119 | 127 |

As can be seen from Table 3, Device Example 1 - Device Example 38 prepared in the present application exhibited good device performance in terms of driving voltage, current efficiency, and device lifetime compared to Comparative Example 1; in addition, the color purity of the device is greatly improved. The improvement in performance of each Device Example is based on the fact that the specific compound materials of the disclosure have a small emission shoulder while having a better electron transport capacity. As can be seen, it is prepared as a light-emitting layer material into an electronic device with higher current efficiency, device lifetime, and color purity while reducing the driving voltage. It is shown that the compounds provided by the disclosure have certain commercial applications. Furthermore, the devices produced by the disclosure are all deep blue devices.

In a preferred embodiment, the structure of Device Example 39 provided by the disclosure is: ITO/P-4 (10 nm)/NPD (60 nm)/HTH-85 (5 nm)/platinum (II) complex : boron-containing compounds : HTH-85:ETH-45 (25 nm) (mass ratio of Pt1 : BN1-8 : HTH-85 : ETH-45 is 10:1:59:30)/ETH-5 (5 nm)/ET-14 (40 nm)/LiQ (1 nm)/Al (100 nm).

Device Example 40 - Device Example 50 were each prepared using a structure similar to Device Example 39, except that platinum (II) complexes as listed in Table 4 were used, respectively: A boron-containing compound was substituted for the platinum (II) complex and the boron-containing compound in Device Example 39. The device structure and light-emitting characteristic data are shown in Table 4.

**Table 4. Data table of device structure and light-emitting characteristics**

| Examples | Platinum (II) complex: Boron-containing compound | Driving voltage (Volts)@10mA/cm² (Relative value, %) | Current efficiency (cd/A) @1000 cd/m² (Relative value, %) | Device lifetime (h) @1000 cd/m² (Relative value, %) |
|---|---|---|---|---|
| Comparative Example 1 | R1 | 100 | 100 | 100 |
| Device Example 39 | Pt1: BN1-8 | 96 | 125 | 130 |
| Device Example 40 | Pt2: BN1-23 | 96 | 125 | 128 |
| Device Example 41 | Pt3: BN2-1 | 97 | 124 | 132 |
| Device Example 42 | Pt4: BN2-26 | 96 | 126 | 129 |
| Device Example 43 | Pt89: BN2-63 | 97 | 129 | 131 |
| Device Example 44 | Pt92: BN2-80 | 97 | 125 | 130 |
| Device Example 45 | Pt147: BN2-86 | 95 | 128 | 142 |
| Device Example 46 | Pt224: BN2-95 | 96 | 130 | 134 |
| Device Example 47 | Pt259: B2-77 | 96 | 129 | 139 |
| Device Example 48 | Pt268: B3-1 | 96 | 132 | 138 |
| Device Example 49 | Pt287: B3-10 | 95 | 131 | 136 |
| Device Example 50 | Pt310: B3-25 | 96 | 129 | 137 |

It can be seen from Table 4 that the complexes of the disclosure can be used as a sensitizer and can be used as a sensitizing material together with a boron-containing compound as a light-emitting material for devices, and the performance of each device is also significantly improved. The addition of boron-containing compounds can further reduce the CIEy value and improve the light-emitting color purity of the device. It is further shown that the complexes provided by the disclosure have certain commercial applications.

The applicant states that the above description is only a specific embodiment of the disclosure, but the scope of protection of the disclosure is not limited thereto, and those skilled in the art should understand that any changes and substitutions that can be easily made by those skilled in the art within the technical scope of the disclosure disclosed are within the scope of protection and disclosure of the disclosure.

## Claims

1. A metal platinum (II) complex, having a structure shown in Formula (I): 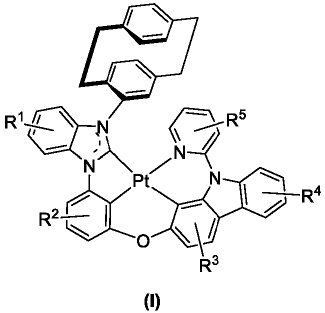 wherein, in Formula (I), R¹ is hydrogen, deuterium; R², R³, R⁴ and R⁵ are each independently represented by mono-, di-, tri-, tetra- or unsubstituted; R², R³, R⁴ and R⁵, equal to or different from each other, are each independently selected from any one or more of the following groups: hydrogen, deuterium, halogen, cyano, substituted or unsubstituted C1-C30 linear or branched alkyl, substituted or unsubstituted C1-C30 linear or branched alkenyl, substituted or unsubstituted C1-C30 linear or branched alkynyl, substituted or unsubstituted C6-C60 monocyclic or polycyclic aryl.

2. The metal platinum (II) complex according to claim 1, wherein R², R³, R⁴ and R⁵, equal to or different from each other, are each independently selected from any one or more of the following groups: hydrogen, deuterium, F, cyano, substituted or unsubstituted C1-C10 linear or branched alkyl, substituted or unsubstituted C6-C30 monocyclic aryl; when containing substituents, the substituents are selected from one or more of deuterium, F, methyl, ethyl, n-propyl, isopropyl, tert-butyl, phenyl.

3. The metal platinum (II) complex according to claim 1, wherein Formula (I) is selected from the following structures, wherein "D" represents deuterium:

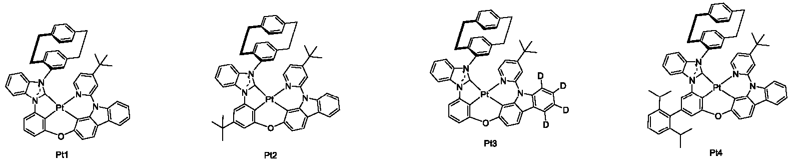

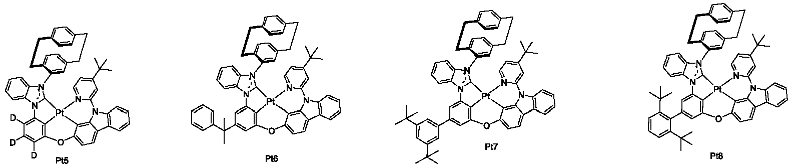

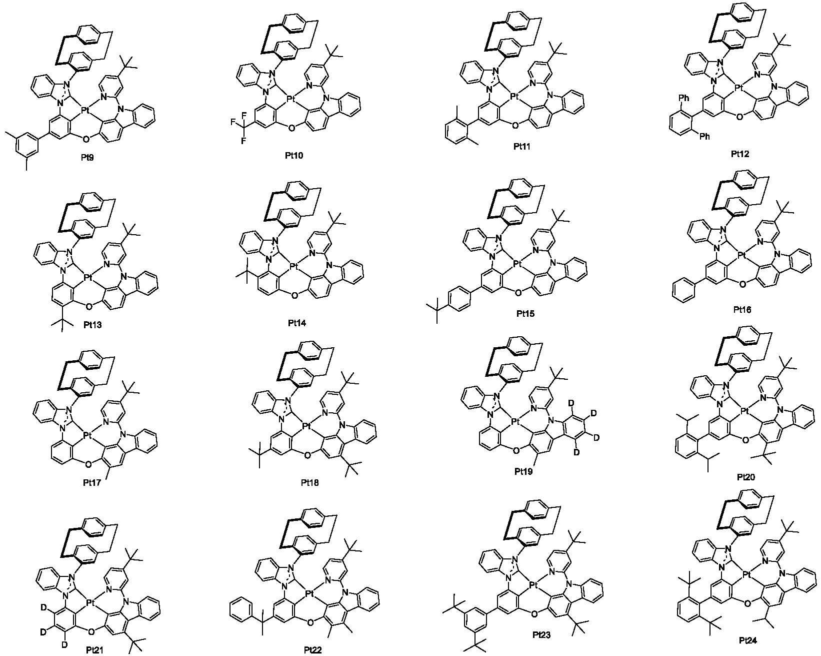

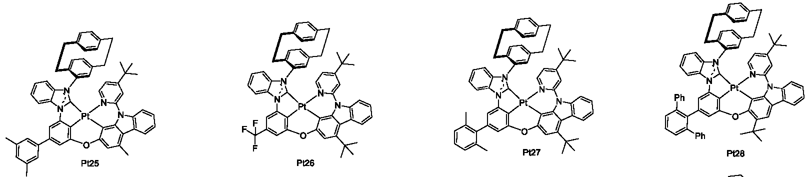

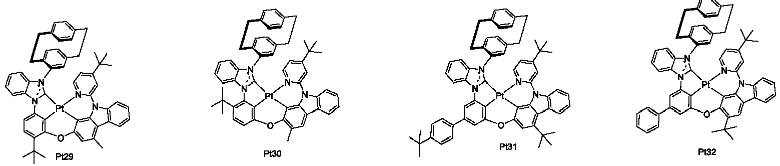

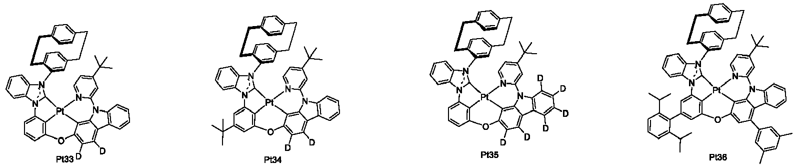

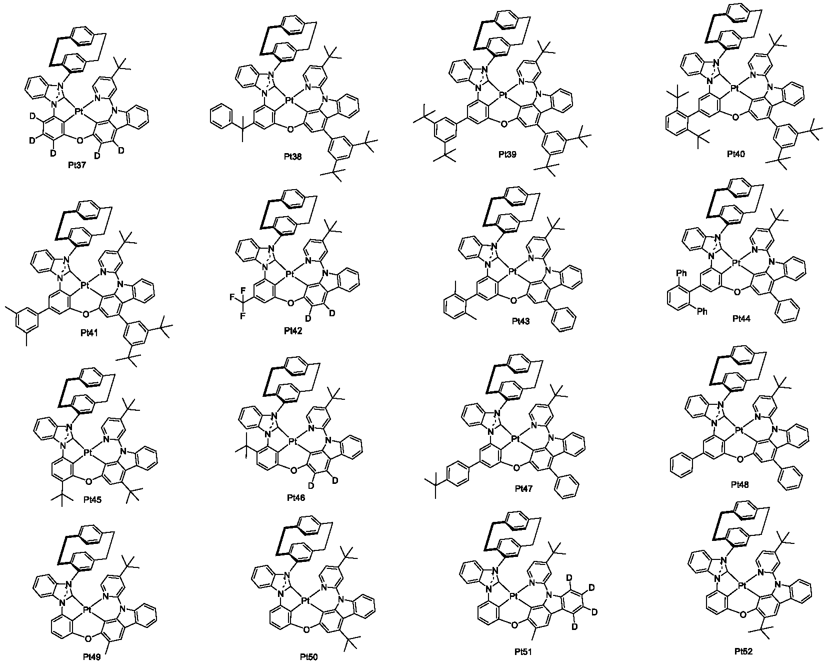

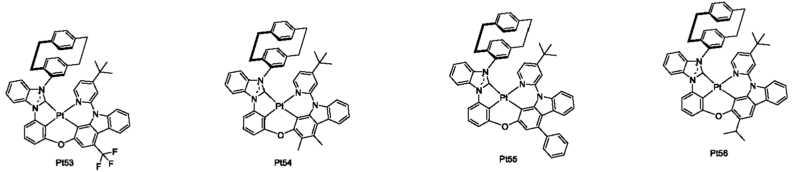

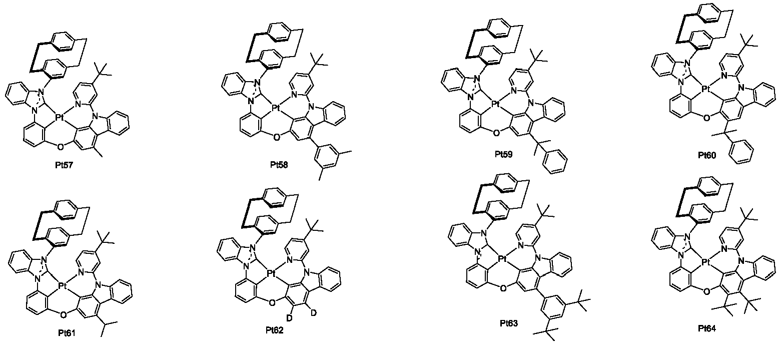

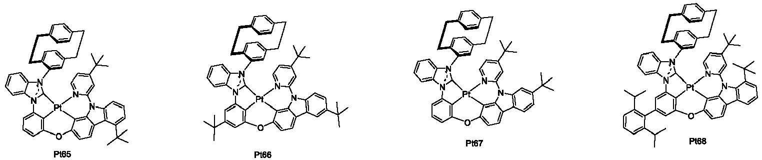

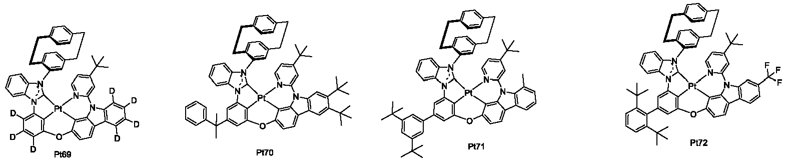

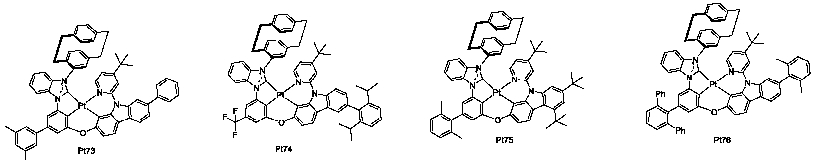

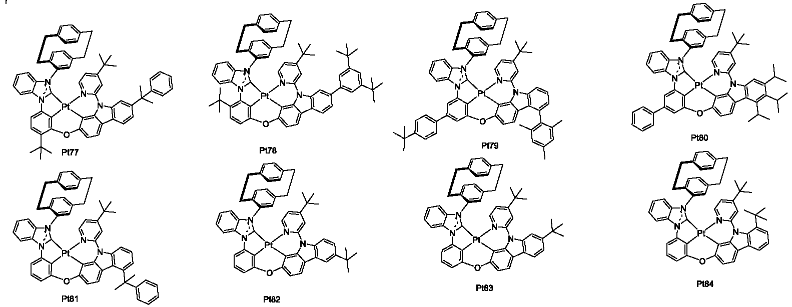

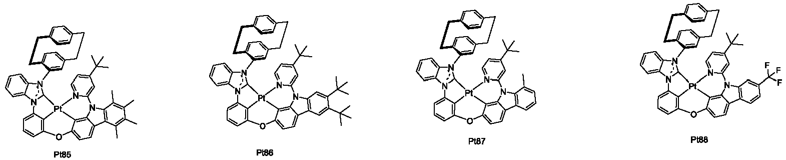

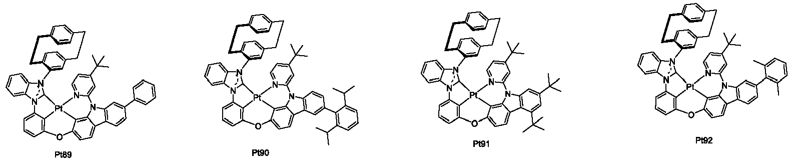

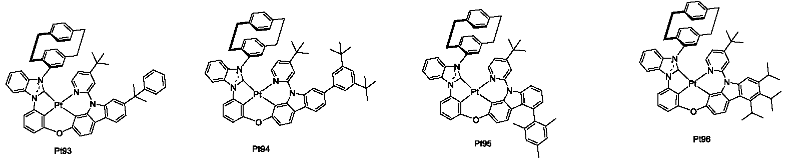

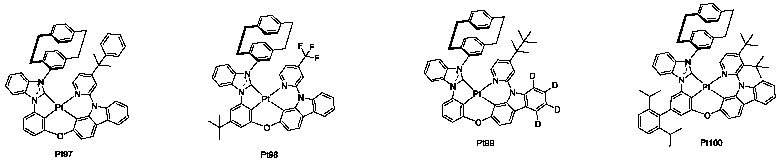

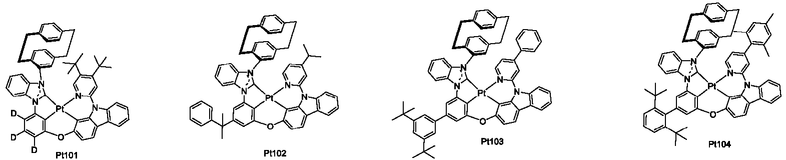

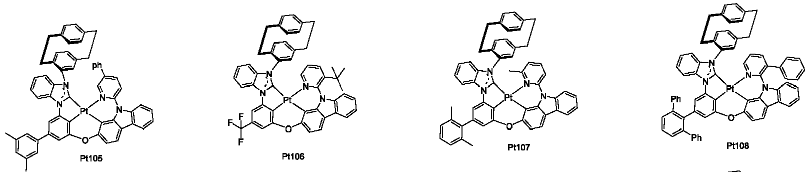

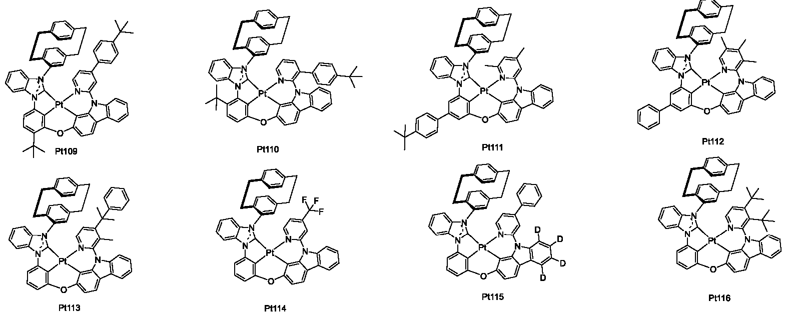

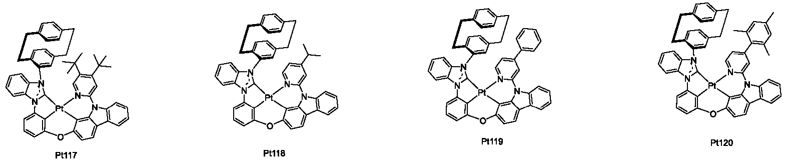

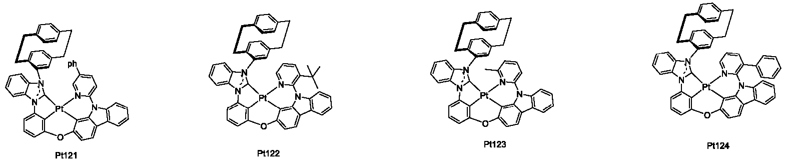

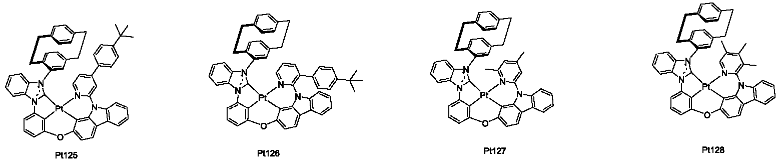

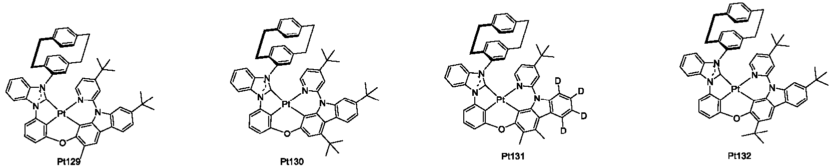

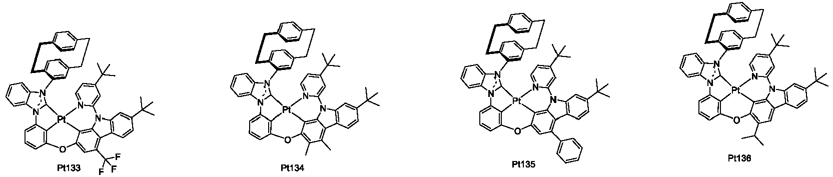

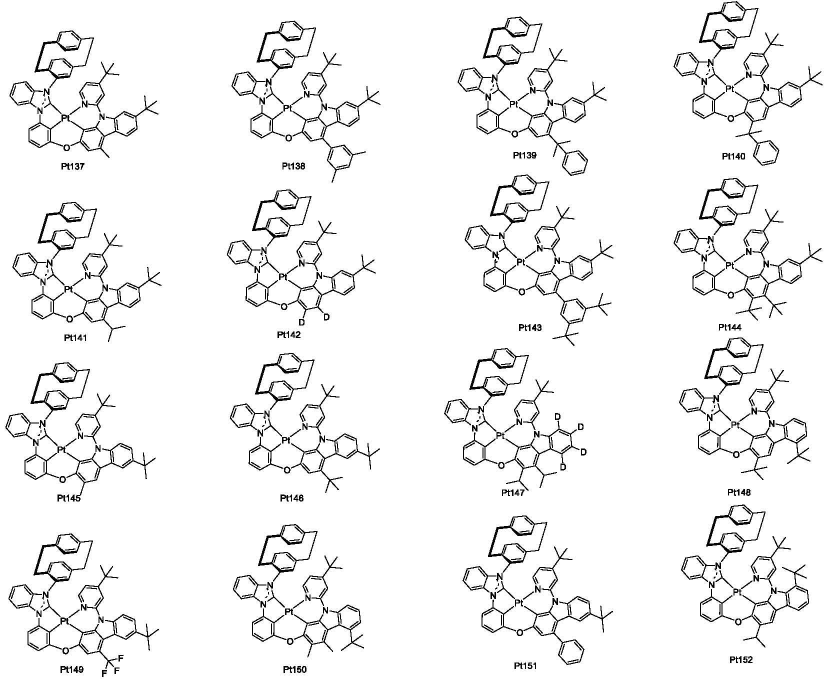

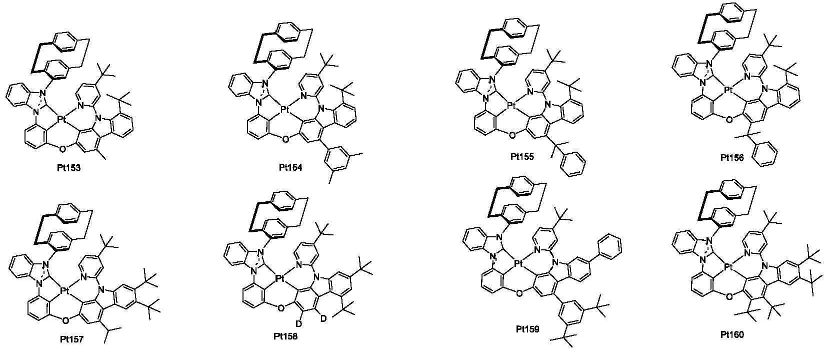

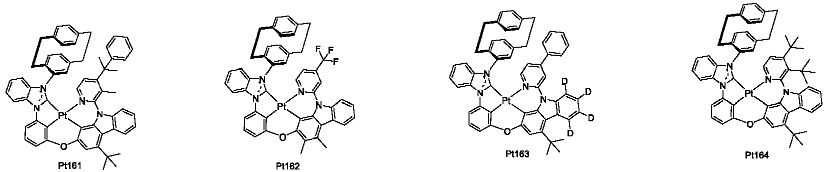

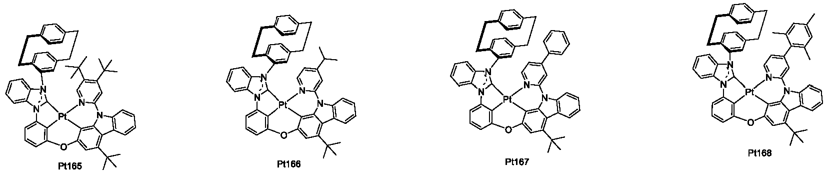

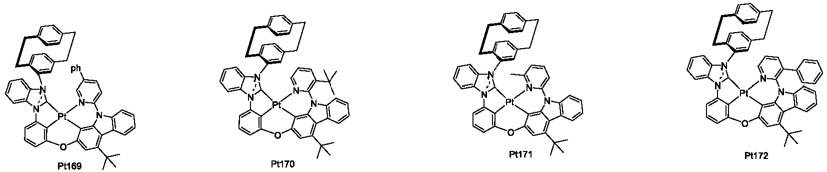

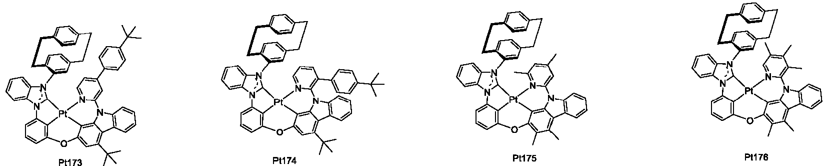

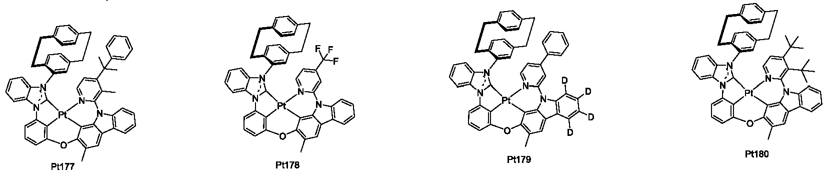

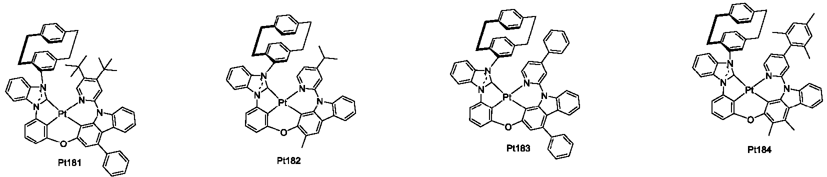

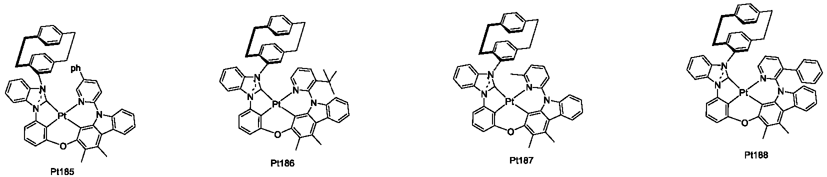

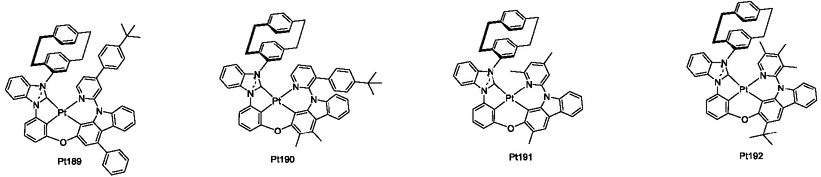

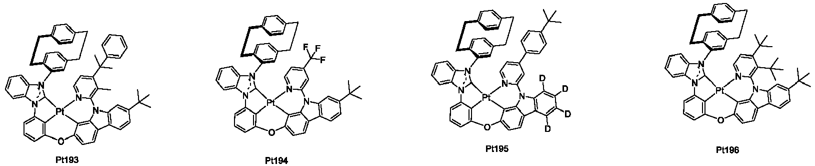

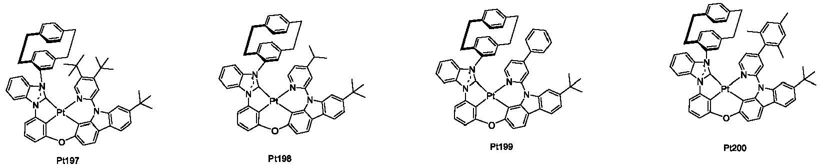

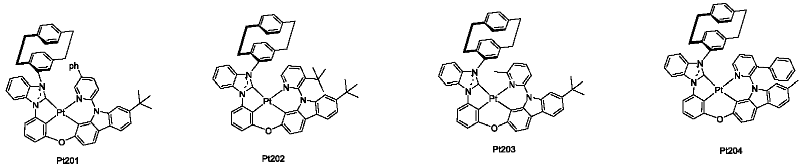

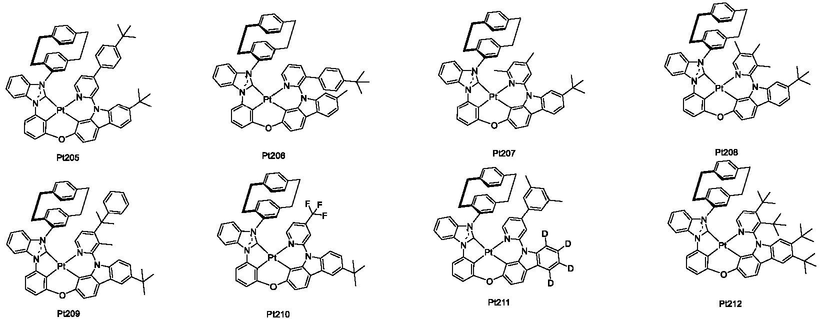

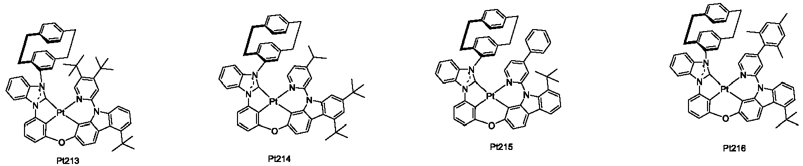

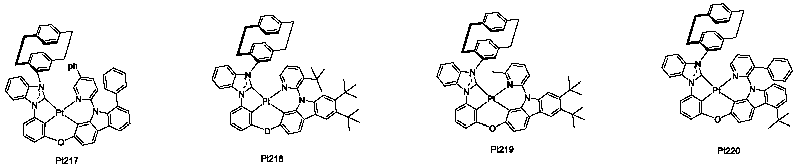

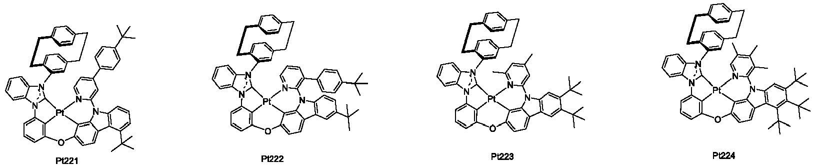

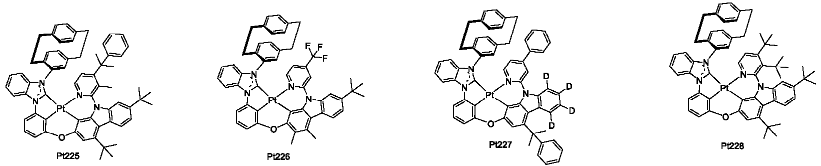

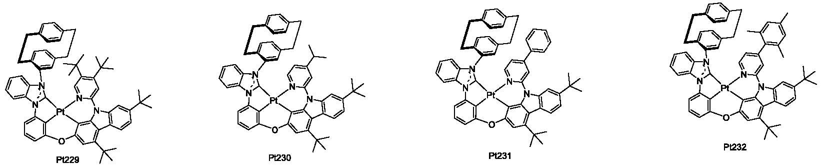

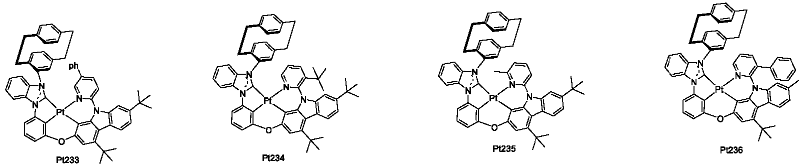

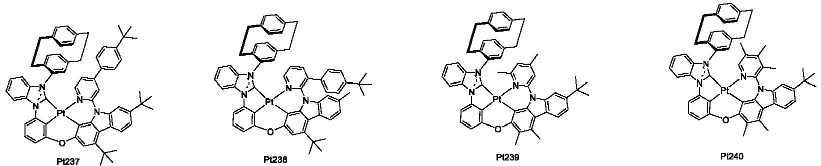

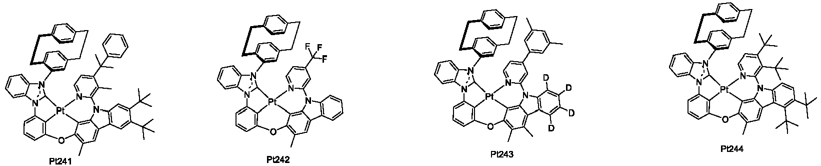

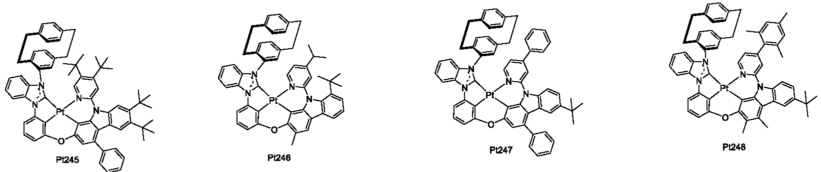

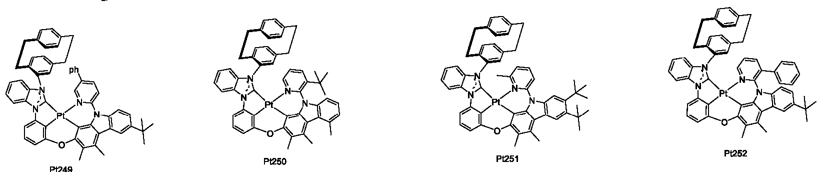

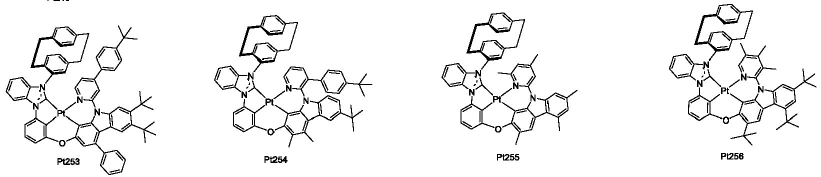

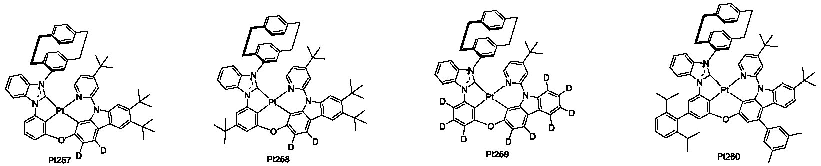

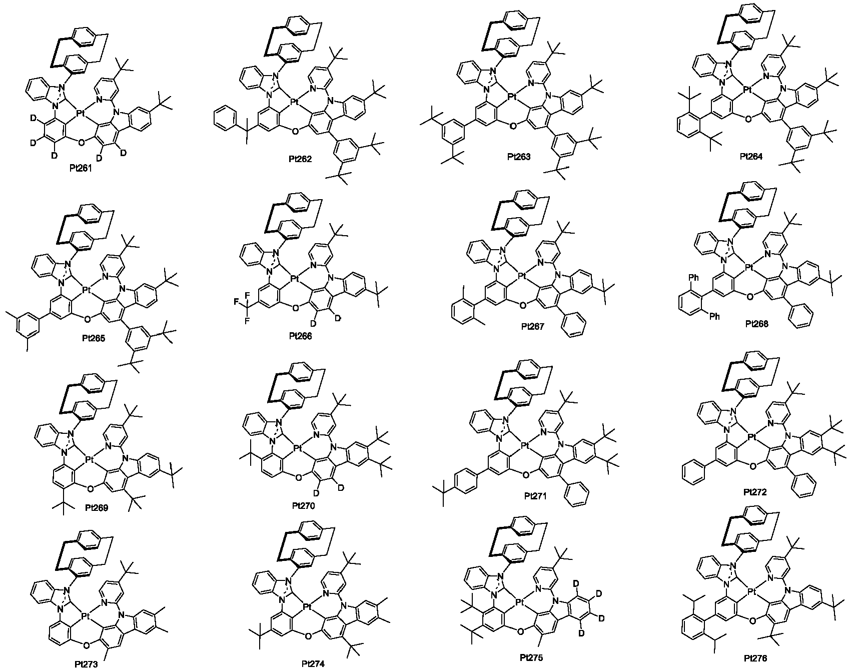

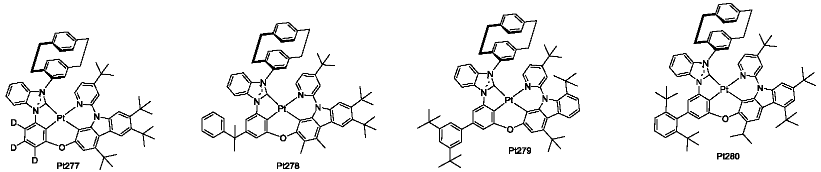

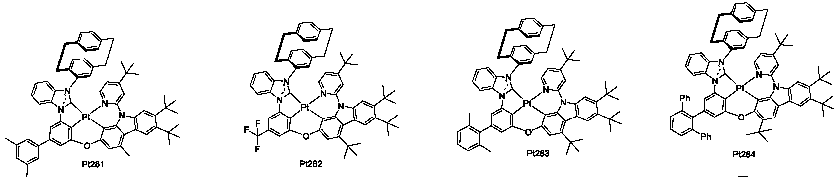

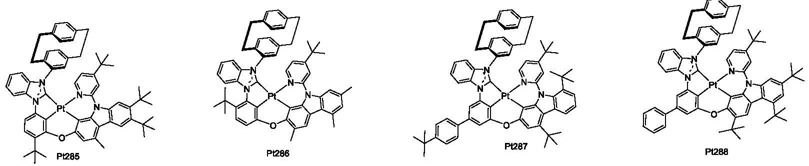

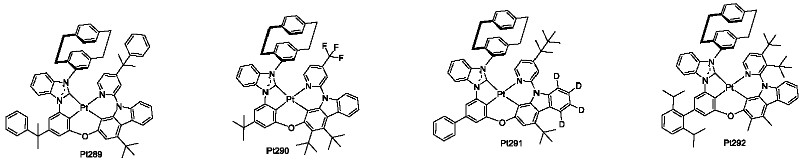

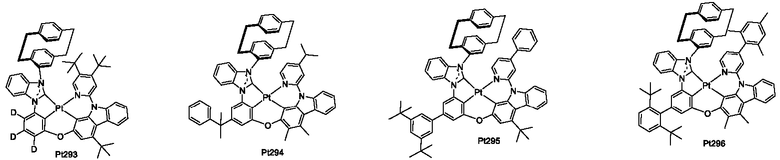

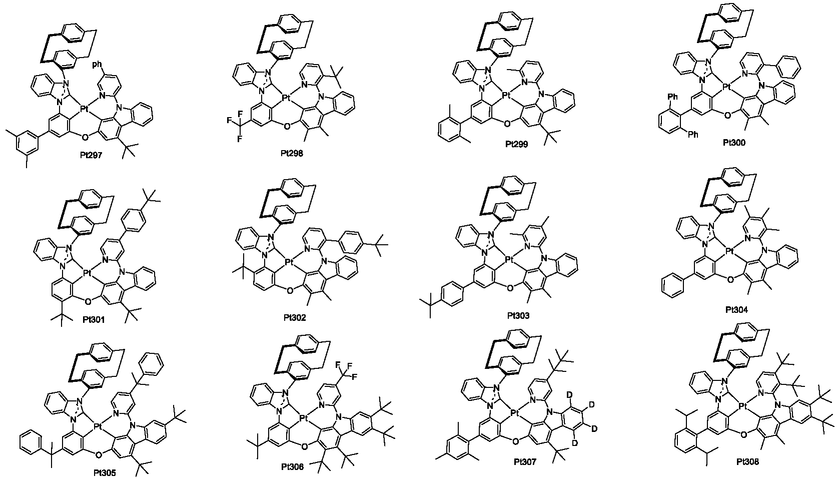

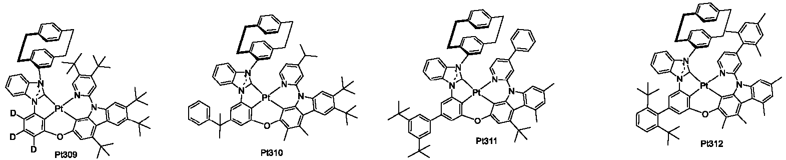

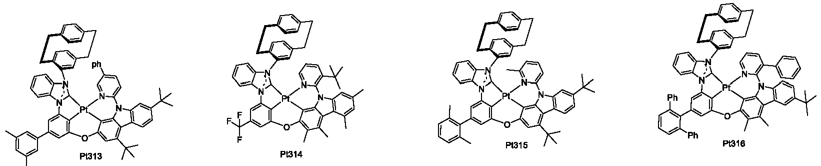

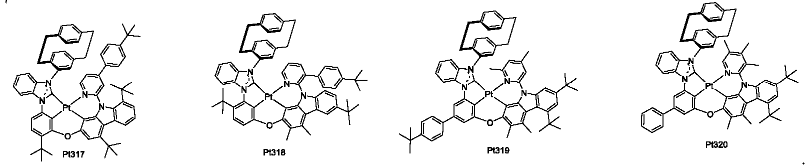

4. Use of the metal platinum (II) complex according to any one of claims 1 to 3 in electronic devices.

5. The use according to claim 4, wherein the electronic device comprises an organic light-emitting diode, a light-emitting electrochemical cell, an OLED sensor, an organic diode, an organic solar cell, an organic transistor, an organic field effect transistor, an organic laser, and a down-conversion element.

6. An organic electroluminescent device, comprising a first electrode; a second electrode facing the first electrode; and an organic functional layer sandwiched between the first electrode and the second electrode; wherein the organic functional layer comprises the metal platinum (II) complex according to any one of claims 1 to 3.

7. The organic electroluminescent device according to claim 6, wherein the organic functional layer comprises a light-emitting layer containing the metal platinum (II) complex according to any one of claims 1 to 3.

8. The organic electroluminescent device according to claim 7, wherein the light-emitting layer further comprises a fluorescent doping material; the fluorescent doping material is selected from any one or more of the compounds having Formula (BN1) - Formula (BN5): 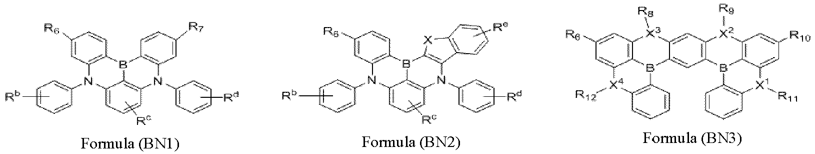 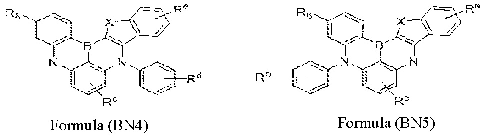
wherein X is O, S, Se, or NR³⁰⁰;
X¹, X², X³, and X⁴ are each independently represented by O, S, Se, or N;
R^{b}-R^{e} are each independently represented by mono-, di-, tri-, tetra-, or unsubstituted; R^{b}-R^{e} are each independently selected from the group consisting of hydrogen, deuterium, N, C1-C30 alkyl, C6-C60 aryl; the R₆-R₁₂ are each independently represented by the group consisting of hydrogen, deuterium, N, C1-C30 alkyl, C6-C60 aryl, and C6-C60 heteroaryl.

9. The organic electroluminescent device according to claim 8, wherein R₆, R₇, and R₁₀ are each independently selected from a substituted or unsubstituted diphenylamino group and a substituted or unsubstituted carbazolyl group; the substitution may be multiple, when containing substituents, the substituents are selected from deuterium, C1-C30 alkyl, and C6-C30 aryl; the R³⁰⁰, R₈, R₉, R₁₁, R₁₂ are each independently selected from the group consisting of hydrogen, C1-C30 alkyl, C6-C60 aryl.

10. An electronic device, comprising: a substrate, an anode, and a cathode, wherein the anode or cathode is provided on the substrate; and a light-emitting material layer disposed between the anode and the cathode, the light-emitting material layer comprising the metal platinum (II) complex according to any one of claims 1 to 3.

11. A composition, comprising the metal platinum (II) complex according to any one of claims 1 to 3.

12. A formulation, comprising the metal platinum (II) complex according to any one of claims 1 to 3 and at least one solvent.

13. A display or lighting apparatus, comprising one or more of the organic electroluminescent devices according to any one of claims 6 to 9.
